(19) Europäisches Patentamt
European Patent Office
Office européen des brevets

(11) EP 2 448 032 B1

(12) **EUROPEAN PATENT SPECIFICATION**

(45) Date of publication and mention of the grant of the patent:
**17.09.2014 Bulletin 2014/38**

(21) Application number: **10792077.9**

(22) Date of filing: **21.06.2010**

(51) Int Cl.:
***H01L 51/44*** *(2006.01)*

(86) International application number:
**PCT/JP2010/060499**

(87) International publication number:
**WO 2010/150759 (29.12.2010 Gazette 2010/52)**

(54) **ORGANIC ELECTRONIC DEVICE AND METHOD FOR PRODUCING THE SAME**

ORGANISCHE ELEKTRONISCHE VORRICHTUNG UND HERSTELLUNGSVERFAHREN DAFÜR

DISPOSITIF ÉLECTRONIQUE ORGANIQUE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **24.06.2009 JP 2009150143**
**07.07.2009 JP 2009160791**

(43) Date of publication of application:
**02.05.2012 Bulletin 2012/18**

(73) Proprietor: **Mitsubishi Chemical Corporation**
**Chiyoda-ku**
**Tokyo 100-8251 (JP)**

(72) Inventors:
- **OIZUMI, Junichi**
**Yokohama-shi, Kanagawa 227-8502 (JP)**
- **FUNAYAMA, Katsuya**
**Yokohama-shi, Kanagawa 227-8502 (JP)**
- **FUJIWARA, Takashi**
**Yokohama-shi, Kanagawa 227-8502 (JP)**
- **YONEYAMA, Takahiro**
**Yokohama-shi, Kanagawa 227-8502 (JP)**
- **HANDA, Keishin**
**Tokyo 108-0014 (JP)**

(74) Representative: **Vossius & Partner**
**Siebertstrasse 4**
**81675 München (DE)**

(56) References cited:
**JP-A- 2007 317 565**
**JP-A- 2007 324 259**
**JP-A- 2009 099 805**
**JP-T- 2007 516 611**
**US-A1- 2007 295 390**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 448 032 B1

## Description

TECHNICAL FIELD:

The present invention relates to an organic electronic device and to a method for manufacturing an organic electronic device.

BACKGROUND ART:

As a technology for protecting solar cells, there has hitherto been proposed a technology for covering a solar cell with a film for the purpose of contriving to realize weight reduction or slimming. In general, solar cell modules are, for example, formed by using a crystal silicon solar cell element or an amorphous silicon solar cell element or the like. Solar cell modules are manufactured by using such a solar cell element and utilizing, for example, a lamination method in which a front surface protective sheet layer, a filler layer, a solar cell element as a photovoltaic element, a filler layer, and a rear surface protective sheet, and so on are laminated in this order, followed by vacuum suction and heat compression, or other method. However, it is known that among solar cell elements, an organic thin film solar cell element, development of which has been advanced in recent years, is weak especially against organic materials generated from constituent members as well as moisture, oxygen or heat. In order to realize a long life of the organic thin film solar cell element, it was necessary to exclude them as far as possible.

Then, for the purposes of preventing deterioration to be caused due to the moisture or oxygen or generated organic materials and keeping the performance over a long period of time, a technology for sealing a scavenger for absorbing moisture or oxygen or generated organic materials, along with the element was developed. For example, in the encapsulation assembly described in Patent Document 1, a scavenger is provided facing an organic semiconductor element across a space. Also, Patent Document 2 shows a sealing panel for organic thin film solar cell element housing in which a hot melt type member containing a moisture scavenger and a wax is disposed between an organic thin film solar cell element and a sealing housing.

Patent Document 3 discloses methods and devices for environmental protection of photovoltaic devices and assemblies. The device comprises an individually encapsulated solar cell, wherein the encapsulated cell includes at least one protective layer coupled to at least one surface of the solar cell and the protective layer may be formed from a substantially inorganic material. The protective layer has a chemical composition that prevents moisture from entering the solar cell and wherein light passes through the protective layer to reach an absorber layer in the solar cell.

PRIOR ART DOCUMENTS:

PATENT DOCUMENTS:

Patent Document 1: JP-T-2007-516611
Patent Document 2: JP-A-2009-99805
Patent Document 3: US 2007/295 390 A1

SUMMARY OF THE INVENTION:

PROBLEMS TO BE SOLVED BY THE INVENTION:

However, when the scavenger comes into contact with an element electrode, there may be caused deterioration of the element. For example, it is known that an alkali metal oxide or an organic metal complex which is used as the moisture scavenger reacts with the scavenged moisture to yield an alkali (hydroxide). When such an alkali comes into contact with an electrode of an organic semiconductor element including an organic thin film solar cell element, it corrodes the electrode, thereby deteriorating the element. In consequence, according to investigations made by the present inventors, it was noted that for realizing a long life, it is very important to avoid the contact between the moisture scavenger and the electrode of the organic semiconductor element.

However, in Patent Document 1, it may be considered that in view of the fact that a space is provided for the purpose of avoiding the contact between the scavenger and the element electrode, the contact between the moisture scavenger and the electrode of the organic semiconductor element is avoided. However, it is the present situation that for the purpose of contriving to realize device slimming, it is difficult to ensure such a space. Then, for realizing device weight reduction, it is effective to cover the device with a film but not glass; however, in the case of a film, when the

device is pressed from above at the time of use, if the space is merely present, the scavenger and the element electrode come into contact with each other. Furthermore, in a flexible organic electronic device using a flexible substrate, when bent, the scavenger and the element electrode come into contact with each other. In the light of the above, by merely providing a space, the problems of the present invention could not be achieved.

Also, in Patent Document 2, it was thought that a method of laminating a hot melt type member layer containing a moisture scavenger so as to come into intimate contact with the top of an organic thin film solar cell element, thereby making it possible to realize device slimming or the like is one of means for achieving the problems of the present invention. However, it was noted that in this laminated structure, there is a possibility that the moisture scavenger comes into direct contact with the electrode. In such case, a reaction product with water yielded in a contacted portion may cause deterioration of the electrode, and there is a high concern that the power generation efficiency is lowered with a lapse of time.

Also, in the case where the moisture scavenger is directly exposed, or is not covered with a film having high gas transmission, the moisture scavenger or the hot melt type member absorbs water or an alkali, a solvent of a adhering agent, a pressure sensitive adhesive, or the like to be used in a process, or the like, to easily denature in a stage to be organized in a manufacturing process of an organic solar cell element module (OPV module), and extreme care must be taken for its handling or process designing.

Then, under the foregoing conventional circumstances, the present invention has been made, and its problems are to provide an organic electronic device which does not deteriorate the device performance over a long period of time, for example, a thin film organic solar cell element in which a lowering of the power generation efficiency is suppressed, and a method for manufacturing the organic electronic device.

MEANS FOR SOLVING THE PROBLEMS:

As a result of extensive and intensive investigations made by the present inventors, it has been found that an organic electronic device which is manufactured in a specified layer configuration is able to solve the foregoing problems, leading to the present invention.

That is, the present invention is as follows.

[1] An organic electronic device comprising: an organic semiconductor element (B) containing at least a pair of electrodes; a layer (C) containing a scavenger which absorbs at least one of moisture and oxygen; and a gas barrier film (D), in this order,
wherein the organic electronic device comprises at least one anticorrosion layer (E) between at least one of the pair of electrodes of the organic semiconductor element (B) and the layer (C) containing a scavenger which absorbs at least one of the moisture and oxygen;
the anticorrosion layer (E) has a film thickness of 20 μm or more; and
the anticorrosion layer (E) and the gas barrier film (D) satisfy requirements of the following expressions (1) and (2):

$$15 \geq Pe > Pd \qquad (1)$$

$$10^{-4} \leq Pd \leq 10^{-1} \qquad (2)$$

wherein Pe represents a water vapor transmission rate of the anticorrosion layer (E) in an environment at 40 °C and 90 % RH, and Pd represents a water vapor transmission rate of the gas barrier film (D) in an environment at 40°C and 90 % RH, and the units thereof are all defined in terms of $g/m^2/day$.

[2] The organic electronic device according to [1] above, wherein the anticorrosion layer (E) includes a layer having an adhesive function of 0.1 N/cm or more.

[3] The organic electronic device according to [1] or [2] above, wherein the organic semiconductor element (B) is an organic solar cell element.

[4] The organic electronic device according to any one of [1] to [3] above, wherein the layer (C) containing a scavenger which absorbs at least one of moisture and oxygen has a moisture absorptivity of 0.1 $mg/cm^2$ or more and not more than 15 $mg/cm^2$.

[5] The organic electronic device according to any one of [1] to [4] above, wherein the gas barrier film (D) is a film including a thermoplastic resin and $SiO_x$ vacuum-deposited on the thermoplastic resin.

[6] The organic electronic device according to any one of [1] to [5] above, which comprises a substrate (A).

[7] The organic electronic device according to any one of [1] to [6] above, which comprises an encapsulant and a

weather resistant protective sheet.

[8] A method for manufacturing an organic electronic device comprising: a substrate (A); an organic semiconductor element (B) containing at least a pair of electrodes; a layer (C) containing a scavenger which absorbs at least one of moisture and oxygen; at least one anticorrosion layer (E); and a gas barrier film (D) for covering the organic semiconductor element (B) as laminated, in this order,

wherein the anticorrosion layer (E) and the gas barrier film (D) satisfy requirements of the following expressions (1) and (2):

$$15 \geq Pe > Pd \qquad (1)$$

$$10^{-4} \leq Pd \leq 10^{-1} \qquad (2)$$

wherein Pe represents a water vapor transmission rate of the anticorrosion layer (E) in an environment at 40 °C and 90 % RH, and Pd represents a water vapor transmission rate of the gas barrier film (D) in an environment at 40°C and 90 % RH, and the units thereof are all defined in terms of g/m$^2$/day,

wherein the method comprises: manufacturing a laminate layer by laminating the at least one anticorrosion layer (E) on the layer (C) containing a scavenger which absorbs at least one of moisture and oxygen; manufacturing the organic semiconductor element (B) on the substrate (A); and laminating the layers in the foregoing order.

[9] The method for manufacturing an organic electronic device according to [8] above, wherein the gas barrier film (D), the layer (C) containing a scavenger which absorbs at least one of moisture and oxygen, and the at least one anticorrosion layer (E) are laminated in this order, to manufacture a laminate layer, and the organic semiconductor element (B) is manufactured on the substrate (A), and the layers are laminated in the foregoing order.

EFFECTS OF THE INVENTION:

According to the present invention, by providing the anticorrosion layer (E) between the organic semiconductor element (B), more specifically the electrode, and the layer (C) containing a scavenger which absorbs at least one of moisture and oxygen, the layer (C) containing a scavenger which absorbs at least one of moisture and oxygen does not come into direct contact with the electrode. As a result, it has become possible to suppress the deterioration of the organic semiconductor element to be caused due to at least one of moisture and oxygen and further to prevent the diffusion of a reaction product of a scavenger-containing component (active materials such as acids, alkalis, radicals, and the like) into an organic semiconductor material through pinholes of the electrode. Furthermore, by disposing the layer (C) containing a scavenger which absorbs at least one of moisture and oxygen within the organic electronic device in such a manner that it does not come into contact with the outside air, it has become possible to realize a long life of the organic electronic device. Specifically, in the organic thin film solar cell, it is not necessary to provide a space for the purpose of avoiding the contact between the scavenger and the electrode, so that it becomes possible to realize device slimming. Also, even when pressed from the top of the film, the scavenger and the electrode do not come into contact with each other, and hence, the organic semiconductor can be covered with a film but not glass, so that it becomes possible to realize device weight reduction. Furthermore, even in the case of a flexible organic electronic device, when bent, the scavenger and the electrode do not come into contact with each other, so that it has become possible to prevent the device deterioration to be caused due to bending.

The organic electronic device of the present invention becomes an organic electronic module which is strong against a pressure in the vertical direction to the light receiving surface. Specifically, in order that after forming the organic thin film solar cell device into a module and placing the module, it may become practically useful, the module is required to be strong against a pressure in the vertical direction to the light receiving surface such that it is durable even in the case where it is treaded, or hail falls. But, in the case where a gap between the organic semiconductor element and the scavenger is merely a space, or in the case where only a film having high gas transmission or the like is present, a risk of receiving damage upon direct contact is high. However, by providing the anticorrosion layer (E) having specified characteristics as in the present invention, this damage can be prevented from occurring.

Also, by providing the anticorrosion layer (E), the moisture scavenger or the hot melt type member becomes free from occurrence of the matter that it absorbs water or an alkali, a solvent of a adhering agent, a pressure sensitive adhesive, or the like to be used in a process, moisture or oxygen of the outside air, etc., or the like, to denature in a stage to be organized in a manufacturing process of an OPV module, so that effects for making its handling operation or process designing simple and robust can be expected. Furthermore, in the present invention, in view of the fact that the substrate (A) and the gas barrier film (D) are adhered to each other directly or via an interlayer (other layer) in such

a manner that the organic semiconductor element (B) and the layer (C) containing a scavenger which absorbs at least one of moisture and oxygen do not come into contact with the outside air, the foregoing effects can be exhibited.

BRIEF DESCRIPTION OF THE DRAWINGS:

Fig. 1 is a schematic view of a section showing a structural example of an organic electronic device of Embodiment I of the present invention (Example 1).
Fig. 2 is a schematic view of a section showing a structural example of an organic electronic device of a comparative example (Comparative Example 1).
Fig. 3 is a schematic view of a section showing a structural example of an organic electronic device of Embodiment 2 of the present invention (Examples 1 and 2).
Fig. 4 is a schematic view of an upper surface showing a structural example of an organic electronic device of Embodiment 2 of the present invention (Examples 1 and 2).
Fig. 5 is a schematic view of a section showing a structural example of an organic electronic device of Embodiment 3 of the present invention (another embodiment of Examples 1 and 2).
Fig. 6 is a schematic view of a section showing a structural example of an organic electronic device of Embodiment 4 of the present invention (Examples 3 and 4).
Fig. 7 is a schematic view of an upper surface showing a structural example of an organic electronic device of Embodiment 4 of the present invention (Examples 3 and 4).

MODES FOR CARRYING OUT THE INVENTION:

The present invention is hereunder described in detail while referring to embodiments, illustrative materials and so on, but it should not be construed that the present invention is limited to the following embodiments and illustrative materials, and so on, and arbitrary modifications can be made therein so far as the gist of the present invention is not deviated.

(Embodiment 1)

The organic electronic device of the present invention, an example of which is shown in Fig. 1, is an organic electronic device comprising an organic semiconductor element (B) 20 provided with at least a pair of electrodes 3 and 4 and an organic semiconductor layer 2, a layer (C) 6 containing a scavenger which absorbs at least one of moisture and oxygen, and a gas barrier film (D) 7 for covering the organic semiconductor element (B) 20 as laminated in this order, wherein at least one anticorrosion layer (E) 5 is provided between at least one of the electrodes and the layer (C) 6 containing a scavenger which absorbs at least one of the moisture and oxygen. Incidentally, here, the organic semiconductor element (B) 20 may be formed on the substrate (A) 1, and the gas barrier film (D) may also be used as a substrate. Here, the organic semiconductor element (B) is configured in such a manner that the organic semiconductor layer 2 is disposed between the transparent electrode 3 and the metal electrode 4, and in the case of a solar cell element, the organic semiconductor element (B) is configured in such a manner that electrons yielded within the organic semiconductor layer 2 by means of photoelectric conversion are collected as an electric power from the transparent electrode 3 and the metal electrode 4.

Then, a film thickness of the anticorrosion layer (E) is 20 μm or more, and
the anticorrosion layer (E) and the gas barrier film (D) satisfy requirements of the following expressions (1) and (2).

$$15 \geq Pe > Pd \qquad (1)$$

$$10^{-4} \leq Pd \leq 10^{-1} \qquad (2)$$

In the foregoing expressions (1) and (2), Pe represents a water vapor transmission rate of the anticorrosion layer (E) in an environment at 40 °C and 90 % RH, and Pd represents a water vapor transmission rate of the gas barrier film (D) in an environment at 40 °C and 90 % RH, and the units thereof are all defined in terms of $g/m^2/day$.

(Embodiment 2); for reference purposes

Also, the organic electronic device of the present invention, an example of which is shown in Figs. 3 and 4, is an organic electronic device comprising at least a substrate (A) 1, an organic semiconductor element (B) 20, a layer (C) 6 containing a scavenger which absorbs moisture and/or oxygen, and a gas barrier film (D) 7 as laminated in this order, wherein a resin layer (F), which is an anticorrosion layer (E) 5 in Figs. 3 and 4, is provided between the organic semiconductor element (B) and the layer (C) 6 containing a scavenger which absorbs at least one of moisture and oxygen in such a manner that the organic semiconductor element (B) and the layer (C) 6 do not come into direct contact with each other, and the substrate (A) 1 and the gas barrier film (D) 7 are adhered to each other directly or via an interlayer such as an anticorrosion layer (E) 5 and the like in such a manner that the organic semiconductor element (B) and the layer (C) 6 do not come into contact with the outside air.

Then, a film thickness of the resin layer (F) is 20 μm or more, and
the resin layer (F) and the gas barrier film (D) satisfy requirements of the following expressions (1) and (2).

$$15 \geq Pe > Pd \qquad (1)$$

$$10^{-4} \leq Pd \leq 10^{-1} \qquad (2)$$

In the foregoing expressions (1) and (2), Pe represents a water vapor transmission rate of the resin layer (F) in an environment at 40 °C and 90 % RH, and Pd represents a water vapor transmission rate of the gas barrier film (D) in an environment at 40 °C and 90 % RH, and the units thereof are all defined in terms of $g/m^2$/day.

Also, the substrate (A) and the gas barrier film (D) are adhered to each other directly or via an interlayer in such a manner that the element (B) and the layer (C) do not come into contact with the outside air.

(Embodiment 3)

Also, in the organic electronic device of the present invention, an example of which is shown in Fig. 5, a layer (C) 6 containing a scavenger is formed on a gas barrier film (D) 7 in which a gas barrier layer such as a non-illustrated rear surface protective sheet and the like is formed; a resin layer (F) configured of an anticorrosion layer (E) 5 is disposed so as to cover this layer (C) 6 containing a scavenger; and the resin layer (F) is adhered to the gas barrier film (D) 7 via a sealing material 8 in such a manner that it is not exposed to the outside without reaching an end face of this organic electronic device. Other members are the same as those in the foregoing Embodiment 2.

(Embodiment 4)

Embodiment 4 is concerned with a method for manufacturing an organic electronic device, and for example, an example thereof expresses a method for manufacturing the organic electronic device shown in Figs. 3 and 4.

That is, as shown in Figs. 3 and 4, this method is a method for manufacturing an organic electronic device including at least a substrate (A) 1, an organic semiconductor element (B) 20, a layer (C) 6 containing a scavenger which absorbs at least one of moisture and oxygen, and a gas barrier film (D) 7 as laminated in this order, wherein a resin layer (F), which is an anticorrosion layer (E) 5 in Figs. 3 and 4, is provided between the organic semiconductor element (B) 20 and the layer (C) 6 containing a scavenger which absorbs at least one of moisture and oxygen in such a manner that the organic semiconductor element (B) 20 and the layer (C) 6 do not come into direct contact with each other, and the substrate (A) 1 and the gas barrier film (D) 7 are adhered to each other directly or via an interlayer in such a manner that the element (B) and the layer (C) 6 do not come into contact with the outside air.

Then, as shown in Figs. 6 and 7, this manufacturing method of an organic electronic device comprises disposing at least two or more organic semiconductor elements (B) 20 while leaving a gap between each other on a substrate (A) 1; laminating a resin layer (F) on the at least two or more organic semiconductor elements (B) 20; disposing two or more pieces of layers (C) 6 containing a scavenger which absorbs at least one of moisture and oxygen while leaving a gap between each other on the resin layer (F), which is an anticorrosion layer (E) 5 in Figs. 6 and 7, and laminating a gas barrier film (D) 7 on the layer (C) 6, following by cutting so as to include the organic semiconductor element (B) 20 and the layer (C) 6 containing a scavenger which absorbs at least one of moisture and oxygen. In this configuration, it is also desirable that the resin layer (F) is the same as that in Embodiment 2; however, with respect to the film thickness and moisture absorptivity, those which do not satisfy the foregoing requirements are also easy for manufacture, and it is possible to contrive to simplify the manufacturing process.

Incidentally, although the organic electronic device according to the present invention is not particularly limited so far as it includes at least the foregoing (B) to (E) layers, it preferably refers to an organic EL device or an organic thin film solar cell element device. Above all, an organic thin film solar cell element device is especially preferable.
Also, in the present invention, all of the sheet, the film and the layer mean a sheet-shaped material and a film-shaped material, and they are not distinguished from each other so far as the functions of the present invention are not impaired.
In the foregoing Embodiments 1 to 4, the same symbols are given to the same members, and descriptions thereof were omitted.
Next, the respective members which are used in the present invention are described.

<Substrate (A)>

The substrate (A) is a supporting member for supporting the organic semiconductor element (B). Examples of a material which forms the substrate (A) include inorganic materials such as glass, sapphire, titania, and the like; organic materials such as polyethylene terephthalate, polyethylene naphthalate, polyether sulfone, polyimide, nylon, polystyrene, polyvinyl alcohol, ethylene vinyl alcohol copolymers, fluorine resin films, vinyl chloride, polyethylene, polypropylene, cyclic polyolefins, cellulose, acetyl cellulose, polyvinylidene chloride, aramid, polyphenylene sulfide, polyurethane, polycarbonate, poly(meth)acrylic resins, phenol resins, epoxy resins, polyallylate, polynorbornene, and the like; metal materials such as stainless steel, titanium, nickel, silver, gold, copper, aluminum, and the like; and so on.
Of these, from the standpoint of easiness of formation of the organic semiconductor element (B), glass, polyethylene terephthalate, polyethylene naphthalate, polyimide, poly(meth)acrylic resin films, stainless steel, and aluminum are preferable.
Incidentally, the material of the base material may be used singly, or two or more kinds thereof may be used jointly in arbitrary combination and ratio. Also, reinforcing fibers such as carbon fibers, glass fibers, and the like may be incorporated into such an organic material, thereby reinforcing the mechanical strength. Also, for the purpose of imparting insulating properties to such a metal material, a composite material such as one obtained by coating or lamination on the surface, and the like may be used. For example, in the case where the substrate (A) is constituted of a metal substrate, a configuration in which a part thereof is imparted insulating properties, and a part thereof is exposed, thereby allowing the substrate to act as a metal electrode; an organic semiconductor element is laminated on an upper layer thereof; and a transparent electrode is further laminated on an upper layer thereof is also applicable. Also, the gas barrier film may be used as the substrate.

<Organic semiconductor element (B)>

Although the organic semiconductor element (B) is hereunder described by reference to an organic thin film solar cell element (also referred to simply as "solar cell element" in the present description), it should not be construed that other organic electronic devices are excluded, so far as they remarkably impair the present invention. Furthermore, it should not be construed that the organic thin film solar cell element is limited to an example as described below.
The organic thin film solar cell element is one provided with at least a pair of electrodes and an organic semiconductor-containing organic semiconductor layer provided therebetween. In such an organic semiconductor layer, light is absorbed to generate an electric power, and the generated electric power is collected from the electrodes, and there may be the case where other layers such as a buffer layer and the like are included as described later.

• Organic semiconductor layer:

The organic semiconductor layer can be formed of an arbitrary organic semiconductor. The organic semiconductor is classified into a p-type and an n-type depending upon semiconductor characteristics. The p-type or the n-type exhibits either a hole or an electron which contributes to electrical conduction and is dependent upon an electronic state, doping state or trap state of the material. In consequence, while examples of the organic semiconductor are shown below, there may be the case where the p-type or the n-type cannot be clearly classified, and the same material may possibly exhibit both characteristics of the p-type and the n-type.
Examples of the p-type semiconductor include porphyrin compounds such as tetrabenzoporphyrin, copper tetrabenzoporphyrin, zinc tetrabenzoporphyrin, and the like; phthalocyanine compounds such as phthalocyanine, copper phthalocyanine, zinc phthalocyanine, and the like; naphthalocyanine compounds; polyacenes such as tetracene and pentacene; oligothiophenes such as sexithiophene and the like; and derivatives containing such a compound as a skeleton. Furthermore, there are exemplified polymers such as polythiophenes inclusive of poly(3-alkylthiophene)s and the like, polyfluorene, polyphenylene vinylene, polytriallylamine, polyacetylene, polyaniline, polypyrrole, and the like; and so on.

Examples of the n-type semiconductor include fullerenes (e.g., C60, C70, and C76); octaazaporphyrin; perfluoro forms of the foregoing p-type semiconductors; aromatic carboxylic acid anhydrides and imides thereof, such as naphthalenetetracarboxylic acid anhydride, naphthalenetetracarboxylic acid diimide, perylenetetracarboxylic acid anhydride, perylenetetracarboxylic acid diimide, and the like; and derivatives containing such a compound as a skeleton; and so on.
So far as at least a p-type semiconductor and an n-type semiconductor are contained, a specific configuration of the organic semiconductor layer is arbitrary. The organic semiconductor layer may be constituted of only a single-layer film, or may be constituted of two or more laminated films. For example, the organic semiconductor layer may be formed so as to contain an n-type semiconductor and a p-type semiconductor in separate films, respectively, or may be formed so as to contain an n-type semiconductor and a p-type semiconductor in the same film.
Each of the n-type semiconductor and the p-type semiconductor may be used singly, or two or more kinds thereof may be used jointly in arbitrary combination and ratio.
Specific examples of the configuration of the organic semiconductor layer include a bulk heterojunction type having a layer (i-layer) in which a p-type semiconductor and an n-type semiconductor are present as separate phases therein; a lamination type (hetero-pn-junction type) in which a layer (p-layer) containing a p-type semiconductor and a layer (p-layer) containing an n-type semiconductor have an interface therebetween, respectively; the Schottky type; and a combination thereof. Of these, the bulk heterojunction type and a p-i-n junction type in which the bulk heterojunction type and the lamination type are combined are preferable because high performances are exhibited.
Although a thickness of each of the p-layer, the i-layer and the n-layer of the organic semiconductor layer is not limited, it is preferable that the thickness is generally 3 nm or more, and especially 10 nm or more, and generally not more than 200 nm, and especially not more than 100 nm. By making the layer thickness thick, the uniformity of the film tends to increase, whereas by making the layer thickness thin, the transmittance tends to be enhanced, and the series resistance tends to be lowered.

• Electrode:

The electrode can be formed of an arbitrary material having electrical conductivity. Examples of materials for the electrode include metals such as platinum, gold, silver, aluminum, chromium, nickel, copper, titanium, magnesium, calcium, barium, sodium, and the like, or alloys thereof; metal oxides such as indium oxide, tin oxide, and the like, or alloys thereof (e.g., ITO); electrically conductive polymers such as polyaniline, polypyrrole, polythiophene, polyacetylene, and the like; materials obtained by incorporating a dopant such as an acid, e.g., hydrochloric acid, sulfuric acid, sulfonic acid, etc., a Lewis acid, e.g., $FeCl_3$, etc., a halogen atom, e.g., iodine, etc., a metal atom, e.g., sodium, potassium, etc., and the like into the foregoing electrically conductive polymer; electrically conductive composite materials obtained by dispersing an electrically conductive particle such as metal particles, carbon black, fullerenes, carbon nanotubes, and the like in a matrix such as a polymer binder and the like; and so on. Above all, a material having a deep work function, such as Au, ITO, and the like, is preferable for the electrode for collecting holes. On the other hand, a material having a shallow work function, such as Al, is preferable for the electrode for collecting electrons. By optimizing the work function, there is brought such an advantage that the holes and electrons yielded by the light absorption are satisfactorily collected.
It is preferable that of the pair of electrodes, at least the electrode on the light receiving surface side has light transmitting properties in view of the power generation. However, the electrode on the light receiving surface side electrode is not always transparent when use of an electrode which is not transparent does not conspicuously adversely affect the power generation performance, as in the case where the area of the electrode is small as compared with the area of the power generation layer. Examples of a material of the transparent electrode include oxides such as ITO, indium-zinc oxide (IZO), and the like; thin metal films; and so on. Also, on that occasion, although there are no limitations on a specific range of the light transmittance, when the power generation efficiency of the solar cell element is taken into account, the light transmittance is preferably 80 % or more, excluding a loss to be caused by partial reflection at the optical interface.
Incidentally, the material of the electrode may be used singly, or two or more kinds thereof may be used jointly in arbitrary combination and ratio.
Incidentally, there are no limitations on the method of forming an electrode. For example, the electrode can be formed by means of a dry process such as vacuum vapor deposition, sputtering, and the like. It is also possible to form the electrode by means of a wet process using, for example, an electrically conductive ink or the like. On that occasion, an arbitrarily electrically conductive ink can be used. For example, an electrically conductive polymer, a metal particle dispersion liquid, and the like can be used.
Furthermore, the electrode may be composed of a laminate of two or more layers, and its characteristics such as electrical characteristic, wetting characteristic, and the like may be improved by means of a surface treatment.

• Other layers:

The organic solar cell element shown above as an example may be provided with other layers than the foregoing organic semiconductor layer and electrode. Incidentally, the positions where other layers are to be formed are arbitrary so far as the power generation by the solar cell element is not impaired. As other layers, there is exemplified a buffer layer.
The buffer layer is, for example, a layer which is provided for the purpose of improving electrical characteristics and the like on the electrode interface facing the organic semiconductor layer side. Examples thereof include poly(ethylenedioxythiophene):poly(styrene sulfonic acid) (PEDOT:PSS), molybdenum oxide, lithium fluoride, 2,9-dimethyl-4,7-diphenyl-1,10-phenanthroline, and the like.

<Layer (C) containing a scavenger which absorbs at least one of moisture and oxygen>

The layer (C) containing a scavenger which absorbs at least one of moisture and oxygen is a film which absorbs at least one of moisture and oxygen. As described above, among the constituent parts of the organic thin film solar cell element, there are included those which are deteriorated by the moisture and also those which are deteriorated by oxygen. It is difficult to contrive to realize a long life while keeping the power generation efficiency unless they are excluded as far as possible.
Then, by covering the solar cell element with the layer (C) containing a scavenger which absorbs at least one of moisture and oxygen, the solar cell element or the like is protected from at least one of moisture and oxygen, thereby keeping the power generation ability high.
Here, different from the foregoing gas barrier film (D), the layer (C) containing a scavenger which absorbs at least one of moisture and oxygen does not disturb the transmission of at least one of moisture and oxygen but absorbs at least one of moisture and oxygen. By using the film which absorbs at least one of moisture and oxygen, in the case of covering the solar cell element with the gas barrier film (D) or the like, the layer (C) containing a scavenger which absorbs at least one of moisture and oxygen scavenges at least one of moisture and oxygen, each of which slightly invades a space formed by the gas barrier film (D) and the sealing material, whereby influences of the moisture against the solar cell element can be excluded.
Specifically, the moisture absorptivity (also referred to as "moisture absorption amount" in the present invention) of the layer (C) containing a scavenger which absorbs at least one of moisture and oxygen is generally 0.1 $mg/cm^2$ or more, preferably 0.5 $mg/cm^2$ or more, and more preferably 1 $mg/cm^2$ or more per unit area relative to the laminated surface. The higher this numerical value, the higher the moisture absorptivity is, and the deterioration of the solar cell element can be suppressed. Also, although an upper limit thereof is not limited, it is generally not more than 15 $mg/cm^2$.
Also, the moisture absorption amount of the layer (C) containing a scavenger per unit volume is generally 1 $mg/cm^3$ or more, preferably 5 $mg/cm^3$ or more, and more preferably 10 $mg/cm^3$ or more. The higher this numerical value, the higher the moisture absorptivity is, and the deterioration of the solar cell element can be suppressed. Also, although an upper limit thereof is not limited, it is generally not more than 800 $mg/cm^3$.
Incidentally, with respect to a measuring method of the moisture absorption amount, the measurement can be carried out by a method of calculating it from a change in weight of a specimen before and after the moisture absorption, a method of measuring a moisture amount in a specimen by a moisture meter, or a method of storing a specimen in a hermetic container containing moisture and detecting a reduction of the moisture by a moisture content meter. A method of calculating the moisture absorption amount from a change in weight is preferable because it can be simply carried out.
Specifically, after measuring a weight of a specimen in a dry state, the specimen is stored in an environment where moisture is present, and a weight when a weight increase has stopped is recorded, a difference of which is then defined as the moisture absorption amount. The storage environment where moisture is present may be properly set up according to the moisture absorptivity so far as a requirement that moisture of the moisture absorption amount of the specimen or more is present is satisfied. Specifically, in a specimen having large moisture absorptivity, in order to make a test time short, the storage may be carried out in a humidity environment of from 50 to 100 % RH or more, whereas in a specimen having small moisture absorptivity, the storage may be carried out in an environment where the moisture content is properly controlled, for example, within a range of from 1 ppm to 1 %. With respect to the environment at the time of weight measurement, although a specimen which irreversibly absorbs moisture may be subjected to weight measurement in a humidity environment of 50 % RH or more, a specimen which reversibly absorbs moisture must be subjected to weight measurement in a high-humidity environment of 85 % RH or more.
Also, in the case where the layer (C) containing a scavenger which absorbs at least one of moisture and oxygen absorbs oxygen, thereby covering the solar cell element with the gas barrier film (D) or the like, the layer (C) containing a scavenger which absorbs at least one of moisture and oxygen scavenges oxygen which slightly invades a space formed by the gas barrier film (D) and the sealing material, whereby influences of oxygen against the solar cell element can be excluded.
The oxygen absorptivity of the layer (C) containing a scavenger which absorbs at least one of moisture and

oxygen is generally 0.01 mL/cm$^2$ or more, preferably 0.05 mL/cm$^2$ or more, and more preferably 0.1 mL/cm$^2$ or more per unit area relative to the laminated surface. The higher this numerical value, the higher the oxygen absorptivity is, and the deterioration of the solar cell element can be suppressed. Also, although an upper limit thereof is not limited, it is generally not more than 20 mL/cm$^2$. In the present invention, the oxygen absorptivity is synonymous with the oxygen absorption amount.

Also, the oxygen absorption amount of the layer (C) containing a scavenger per unit volume is generally 0.1 mL/cm$^3$ or more, preferably 0.5 mg/cm$^3$ or more, and more preferably 1 mg/cm$^3$ or more. The higher this numerical value, the higher the moisture absorptivity is, and the deterioration of the solar cell element can be suppressed. Also, although an upper limit thereof is not limited, it is generally not more than 200 mg/cm$^3$.

Incidentally, with respect to a measuring method of the oxygen absorptivity, the calculation is carried out by a method of storing a specimen in a hermetic container containing oxygen and detecting a reduction of oxygen by an oxygen content meter. An oxygen content when a reduction of the oxygen content has stopped is recorded, and a difference from the oxygen content within the hermetic container before the test is defined as the oxygen absorption amount. An initial oxygen content within the hermetic container may be properly set up in such a manner that oxygen of the oxygen absorption amount of the specimen or more is present and reaches a content adapted to the sensitivity of the oxygen content meter. Also, the specimen within the hermetic container may be properly charged in an amount that a reduction of oxygen to be caused due to the absorption is the detection sensitivity of the oxygen content meter or more.

Furthermore, in the case where the layer (C) containing a scavenger which absorbs at least one of moisture and oxygen is used on the surface on the light receiving side of the solar cell, a material capable of transmitting visible light therethrough is preferable from the viewpoint of not disturbing the light absorption of the solar cell element. For example, a light transmittance to visible light (wavelength: 360 to 830 nm) is generally 75 % or more, preferably 80 % or more, more preferably 85 % or more, still more preferably 90 % or more, and especially preferably 95 % or more, excluding a loss to be caused by partial reflection at the optical interface. Above all, the light transmittance is particularly preferably 97 % or more. This is because sunlight is more likely converted into electrical energy.

Furthermore, since the organic semiconductor device is frequently heated upon receiving light, it is preferable that the layer (C) containing a scavenger which absorbs at least one of moisture and oxygen also has resistance to heat. From this viewpoint, a melting point of a constituent material of the layer (C) containing a scavenger which absorbs at least one of moisture and oxygen is generally 100 °C or higher, preferably 120 °C or higher, and more preferably 130 °C or higher, and generally not higher than 350 °C, preferably not higher than 320 °C, and still more preferably not higher than 300 °C. By making the melting point high, the possibility of fusion and deterioration of the layer (C) containing a scavenger which absorbs at least one of moisture and oxygen at the time of use of the organic semiconductor device can be reduced.

The material constituting the layer (C) containing a scavenger which absorbs at least one of moisture and oxygen is arbitrary so far as it is able to absorb at least one of moisture and oxygen. Examples of the material include, as materials capable absorbing moisture (e.g., water absorbing agents and drying agents), alkali metals, alkaline earth metals, alkaline earth metal oxides, alkali metal or alkaline earth metal hydroxides, silica gel, zeolite based compounds, sulfates such as magnesium sulfate, sodium sulfate, nickel sulfate, and the like, aluminum metal complexes, organometallic compounds such as aluminum oxide octylate and the like, and so on. Specifically, examples of the alkaline earth metal include Ca, Sr, Ba, and so on. Examples of the alkaline earth metal oxide include CaO, SrO, BaO, and so on. Besides, there are exemplified Zr-Al-BaO, aluminum metal complexes, and so on. Of these, alkaline earth metals such as Ca and Sr and oxides thereof such as CaO and SrO, and aluminum metal complexes are preferable. Furthermore, CaO, SrO, and BaO are more preferable from the standpoint of high moisture scavenging properties, and aluminum metal complexes are more preferable in view of the fact that they are able to make the scavenger transparent.

Among the more preferred materials, when specific trade names are exemplified, for example, it is more preferable to use OleDry (manufactured by Futaba Corporation) as a scavenger which absorbs moisture.

Examples of a material which absorbs oxygen (oxygen scavenger) include inorganic materials such as Fe, Mn, Zn, inorganic salts, e.g., sulfates, chloride salts or nitrates of such a metal, etc., and the like; organic materials such as ascorbic acid, hydrazine based compounds, MXD6 nylon, ethylenically unsaturated hydrocarbons, cyclohexene group-containing polymers, and the like; and so on.

Incidentally, the layer (C) containing a scavenger which absorbs at least one of moisture and oxygen may be formed of a single kind of material or two or more kinds of materials.

As a preferred combination of scavengers constituting the layer (C) containing a scavenger which absorbs at least one of moisture and oxygen, in the case of a combination of scavengers, each of which absorbs moisture, a combination of Ca or Sr as an alkaline earth metal and Cao or SrO as an alkaline earth metal oxide, or a combination of CaO or SrO as an alkaline earth metal oxide and an aluminum metal complex is preferable from the standpoint of a moisture scavenging performance; and in the case of a combination of a scavenger which absorbs moisture and a scavenger which absorbs oxygen, a combination of CaO or SrO as an alkaline earth metal oxide and Fe, a combination

of CaO or SrO as an alkaline earth metal oxide and ascorbic acid, a combination of CaO or SrO as an alkaline earth metal oxide and a hydrazine compound, a combination of an aluminum metal complex and ascorbic acid, or a combination of an aluminum metal complex and a hydrazine compound is preferable from the standpoint of making both the absorption of moisture and the absorption of oxygen compatible with each other. A combination of CaO or SrO as an alkaline earth metal oxide and ascorbic acid, or a combination of CaO or SrO as an alkaline earth metal oxide and a hydrazine compound is more preferable in view of the fact that a higher absorbing performance is exhibited.

Also, although the layer (C) containing a scavenger which absorbs at least one of moisture and oxygen may be formed of a single-layer film, it may be a laminated film provided with two or more layers of films.

Although a thickness of the layer (C) containing a scavenger which absorbs at least one of moisture and oxygen is not particularly specified, it is generally 5 μm or more, preferably 10 μm or more, and more preferably 15 μm or more, and generally not more than 500 μm, preferably not more than 400 μm, and more preferably not more than 300 μm. By making the thickness thick, the mechanical strength tends to increase, whereas by making the thickness thin, the flexibility tends to be enhanced, and furthermore, there is brought such an advantage that the device can be made slim. For that reason, it is desirable to set up a range where the both advantages are revealed to the foregoing range.

In the organic electronic device, since its light receiving surface and rear surface are frequently formed so as to have an area larger than those of other surfaces, there is a tendency that moisture and oxygen invade via these surfaces. From this viewpoint, in the present invention, the layer (C) containing a scavenger which absorbs at least one of moisture and oxygen is provided between the gas barrier film (D) and the organic semiconductor element (B).

In one of the present embodiments, the layer (C) containing a scavenger which absorbs at least one of moisture and oxygen is disposed on the light receiving surface side of the organic semiconductor element (B). Also, in another of the present embodiments, the layer (C) containing a scavenger which absorbs at least one of moisture and oxygen is disposed on the rear surface side of the organic semiconductor element (B). Furthermore, in still another of the present embodiments, the layer (C) containing a scavenger which absorbs at least one of moisture and oxygen is disposed on both the light receiving surface and rear surface sides. In that case, it is preferable that the layer (C) containing a scavenger which absorbs at least one of moisture and oxygen is positioned between the organic semiconductor element (B) and the gas barrier film (D) on each of the light receiving surface and the rear surface.

In addition to the foregoing positions, a position of the layer (C) containing a scavenger which absorbs at least one of moisture and oxygen is not limited so far as it is located within a space formed by the gas barrier film (D) and the sealing material. For example, the layer (C) containing a scavenger which absorbs at least one of moisture and oxygen may be disposed on the substrate (A) where the organic semiconductor element (B) is not present, on the gas barrier film (D) other than the projected surface of at least one of the light receiving surface and the rear surface of the organic semiconductor element (B), or on the device periphery, especially at a position along the inside of the sealing material.

The layer (C) containing a scavenger which absorbs at least one of moisture and oxygen can be formed by an arbitrary method according to the type of the scavenger. For example, a method of attaching a film having a scavenger dispersed therein with a pressure sensitive adhesive; a method of coating a solution of the scavenger by means of roll coating, gravure coating, knife coating, dip coating, curtain flow coating, spray coating, bar coating, die coating, spin coating or inkjetting, by using a dispenser, or other means. Also, a film forming method such as plasma CVD, vacuum vapor deposition, ion plating, sputtering method, and the like may be adopted.

As the film for the scavenger, for example, a polyethylene based resin, a polypropylene based resin, a cyclic polyolefin based resin, a polystyrene based resin, an acrylonitrile-styrene copolymer (AS resin), an acrylonitrile-butadiene-styrene copolymer (ABS resin), a polyvinyl chloride based resin, a fluorine based resin, a poly(meth)acrylic resin, a polycarbonate based resin, and so on can be used. Above all, films of a polyethylene based resin, a fluorine based resin, a cyclic polyolefin based resin, or a polycarbonate based resin are preferable. Incidentally, the foregoing resin may be used singly, or two or more kinds thereof may be used jointly in arbitrary combination and ratio.

Also, in the layer (C) containing a scavenger which absorbs at least one of moisture and oxygen to be disposed on the rear surface of the solar cell element opposite to the light receiving surface, since the constituent member on the back side relative to the solar cell element is not always required to transmit visible light therethrough, a material which does not transmit visible light therethrough can also be used. Also, it is possible to use a film containing at least one of a moisture absorbing agent and an oxygen absorbing agent, each of which is to be used, in a larger amount than that in the layer (C) containing a scavenger which absorbs at least one of moisture and oxygen. As such an absorbing agent, examples of the moisture absorbing agent include CaO, BaO, and Zr-Al-BaO; and examples of the oxygen absorbing agent include active carbon, molecular sieves, and so on.

<Gas barrier film (D) (for covering the organic semiconductor element (B))>

The gas barrier film (D) is a film for preventing the transmission of water and oxygen from occurring.

The organic semiconductor element (B) inclusive of an organic thin film solar cell is liable to be weak against damp and oxygen, and the transparent electrode, metal electrode and organic semiconductor layer may possibly be

deteriorated by moisture and oxygen. Then, by covering the solar cell element with the gas barrier film (D), it is possible to protect the solar cell element from water and oxygen, thereby keeping the power generation ability high.

Incidentally, the gas barrier film (D) in the present invention satisfies the following water vapor transmission rate.

In order to block the invasion of moisture from the outside, a water vapor transmission rate Pd of the gas barrier film (D) in a thickness of 100 $\mu$m in an environment at 40 °C and 90 % RH is required to be not more than $10^{-1}$ g/m$^2$/day. However, it is preferable that the barrier performance is high as far as possible such that the water vapor transmission rate is more preferably not more than $10^{-2}$ g/m$^2$/day, still more preferably not more than $10^{-3}$ g/m$^2$/day, and not more than $10^{-4}$ g/m$^2$/day.

However, according to the current technologies, when the gas barrier film (D) is increased on the barrier performance while keeping the transparency and flexibility, the manufacturing costs increase linking thereto. Therefore, in the case of use for a solar cell application, in view of the fact that restrictions of the manufacturing costs are large, in general, when the water vapor transmission rate falls within the range of from $10^{-3}$ g/m$^2$/day to $10^{-4}$ g/m$^2$/day, an actually most preferred barrier performance is revealed. Incidentally, if technically possible, needless to say, it is more desirable that the water vapor transmission rate is not more than $10^{-4}$ g/m$^2$/day.

The water vapor transmission rate is measured by an apparatus equipped with a humidity sensor, an infrared sensor, and a gas chromatograph in conformity with JIS K7129 in an environment at 40 °C and 90 % by a dish method (JIS Z0208).

Incidentally, there may be the case where in order to improve optical characteristics or mechanical characteristics by burying a vacated space within the organic electronic device, it is necessary to enclose a filler. On that occasion, in the case where a filler layer is made of a material containing a free acid, an organic solvent, a water vapor, oxygen, or the like, there is a concern that the organic semiconductor element is deteriorated. In such case, by disposing an anticorrosion layer between the filler layer and the organic semiconductor element, the deterioration of the organic semiconductor element can be prevented from occurring.

A degree of oxygen transmission required for the gas barrier film (D) varies depending upon the kind of the organic semiconductor element (B) or the like. For example, in general, an oxygen transmission rate in a thickness of 100 $\mu$m in an environment at 25 °C per unit area (1 m$^2$) per day is preferably not more than 1 cc/m$^2$/day/atm, more preferably not more than $1 \times 10^{-1}$ cc/m$^2$/day/atm, still more preferably not more than $1 \times 10^{-2}$ cc/m$^2$/day/atm, yet still more preferably not more than $1 \times 10^{-3}$ cc/m$^2$/day/atm, even yet still more preferably not more than $1 \times 10^{-4}$ cc/m$^2$/day/atm, and especially preferably not more than $1 \times 10^{-5}$ cc/m$^2$/day/atm. When oxygen does not transmit as far as possible, there is brought such an advantage that the deterioration to be caused due to oxidation of the element is suppressed. Incidentally, the oxygen transmission rate can be measured by an apparatus on the basis of a differential pressure method in conformity with JIS K7126A, or measured by an apparatus equipped with an infrared sensor and a gas chromatograph on the basis of an equal pressure method in conformity with JIS K7126B.

By applying such gas barrier film (D), it becomes easy to carry out an organic semiconductor device while making the best of excellent properties of the organic solar cell element or the like.

Also, when used for the light incident/outgoing surface of the organic electronic device, the gas barrier film (D) is preferably one capable of transmitting visible light therethrough. For example, a light transmittance to visible light (wavelength: 360 to 830 nm) is generally 75 % or more, preferably 80 % or more, more preferably 85 % or more, still more preferably 90 % or more, and especially preferably 95 % or more. Above all, the light transmittance is particularly preferably 97 % or more. For example, in the organic thin film solar cell, there is brought such an advantage that sunlight is more likely converted into electrical energy. Also, when used for a surface opposite to the light incident/outgoing surface of the organic electronic device, the gas barrier film (D) is not always required to transmit visible light therethrough, and therefore, it may be opaque.

Although a thickness of the gas barrier film is not particularly specified, it is generally 10 $\mu$m or more, preferably 15 $\mu$m or more, and more preferably 20 $\mu$m or more, and generally not more than 500 $\mu$m, preferably not more than 300 $\mu$m, and more preferably not more than 200 $\mu$m. By making the thickness thick, the mechanical strength tends to increase, whereas by making the thickness thin, the flexibility tends to be enhanced.

Furthermore, since the organic semiconductor device is frequently heated upon receiving light, it is preferable that the gas barrier film (D) also has resistance to heat. From this viewpoint, a melting point of a constituent material of the gas barrier film (D) is generally 100 °C or higher, preferably 120 °C or higher, and more preferably 130 °C, or higher, and generally not higher than 350 °C, preferably not higher than 320 °C, and still more preferably not higher than 300 °C. By making the melting point high, the fusion and deterioration of the gas barrier film (D) at the time of use of the organic semiconductor device can be prevented from occurring.

A specific configuration of the gas barrier film (D) is arbitrary so far as it is able to protect the organic semiconductor element from at least one of water and oxygen. However, since the manufacturing costs of a film capable of minimizing an amount of a water vapor or oxygen which is able to transmit through the gas barrier film (D) become high, it is preferable to use an adequate film while synthetically taking into consideration such an aspect.

A configuration of the gas barrier film (D) is hereunder described by referring to examples.

The following two examples are preferable as the configuration of the gas barrier film (D).

A first example is concerned with a film in which an inorganic barrier layer is disposed on a plastic film base material.

On that occasion, the inorganic barrier layer is formed on only one surface of the plastic film base material, or may be formed on the both surfaces of the plastic film base material. When the inorganic barrier layer is formed on both surfaces of the plastic film base material, a number of the inorganic barrier layers to be formed on each of the surfaces of the plastic film base material may be the same as or different from each other.

A second example is concerned with a film in which a unit layer composed of two layers in which an inorganic barrier layer and a polymer layer are laminated and disposed adjoining to each other is formed on the plastic film base material. On that occasion, when the unit layer composed of two layers in which an inorganic barrier layer and a polymer layer are laminated and disposed adjoining to each other is defined as one unit, although only one unit (meaning one unit of a combination of one inorganic barrier layer and one polymer layer) may be formed as this unit layer, two or more units may be formed. For example, from 2 to 5 units may be laminated.

The unit layer is formed on only one surface of the plastic film base material, or may be formed on the both surfaces of the plastic film base material. When the unit layer is formed on each of the surfaces of the plastic film base material, a number of the inorganic barrier layer and the polymer layer to be formed on each of the surfaces of the plastic film base material may be the same as or different from each other. Also, in the case where the unit layer is formed on the plastic film base material, the inorganic barrier layer may be formed on the side of the plastic film base material, and the polymer layer may be formed on this inorganic barrier layer. The polymer layer may be formed on the side of the plastic film base material, and the inorganic barrier layer may be formed on this polymer layer.

Furthermore, for the purpose of protecting the barrier layer or other purposes, a protective film may be provided on the surface on which the barrier layer is disposed. For such a protective film, a material the same as or different from the material of the gas barrier film base material may be used. Also, a laminate in which the surfaces on which the barrier layer is disposed are stuck to each other, and the plastic film base material is faced outward may be formed.

• Plastic film base material:

The plastic film base material which is used for the gas barrier film (D) is not particularly limited so far as it is a film capable of holding the foregoing inorganic barrier layer and polymer layer, and it can be properly selected according to the use purpose of the gas barrier film (D) or the like.

Examples of a material of the plastic film base material include thermoplastic resins such as polyester resins, methacrylic resins, methacrylic acid-maleic acid copolymers, polystyrene, fluorine resins, polyimide resins, fluorinated polyimide resins, polyamide resins, polyvinyl alcohol resins, polyamide-imide resins, polyether imide resins, cellulose acylate resins, polyurethane resins, polyetheretherketone resins, polycarbonate resins, alicyclic polyolefin resins, polyallylate resins, polyether sulfone resins, polysulfone resins, cycloolefin copolymers, fluorene ring-modified polycarbonate resins, alicyclic modified polycarbonate resins, acryloyl compounds, and the like; and so on.

Of these resins, preferred examples thereof include polyester resins, polyallylate resins, polyether sulfone resins, fluorene ring-modified polycarbonate resins, alicyclic modified polycarbonate resins, and acryloyl compounds. It is also preferable to use a condensed polymer inclusive of spirobiindane and spirobicromane. Among the polyester resins, biaxially stretched polyethylene terephthalate (PET) and biaxially stretched polyethylene naphthalate (PEN) are preferably used as the plastic film base material in the present invention because they are excellent in thermal dimensional stability.

Incidentally, the material of the plastic film base material may be used singly, or two or more kinds thereof may be used jointly in arbitrary combination and ratio.

A layer of an anchor coating agent (anchor coat layer) may be formed on the plastic film base material for the purpose of enhancing the adhesion to the inorganic barrier layer. In general, the anchor coat layer is formed by coating an anchor coating agent. Examples of the anchor coating agent include polyester resins, urethane resins, acrylic resins, oxazoline group-containing resins, carbodiimide group-containing resins, epoxy group-containing resins, isocyanate-containing resins, and copolymers thereof; and so on. Incidentally, the anchor coating agent may be used singly, or two or more kinds thereof may be used jointly in arbitrary combination and ratio.

A thickness of the anchor coat layer is generally 0.005 $\mu$m or more, and preferably 0.01 $\mu$m or more, and generally not more than 5 $\mu$m, and preferably not more than 1 $\mu$m. So far as the thickness is an upper limit value of this range or less, the slipperiness is satisfactory, and the separation from the plastic film base material to be caused due to an internal stress of the anchor coat layer itself does not substantially occur. Also, so far as the thickness is a lower limit value of this range or more, the thickness can be kept uniform, and such is preferable.

• Inorganic barrier layer:

The inorganic barrier layer is generally a layer formed of a metal oxide, nitride or oxynitride. Incidentally, the metal oxide, nitride or oxynitride which forms the inorganic barrier layer may be used singly, or two or more kinds thereof may be used jointly in arbitrary combination and ratio.

Examples of the metal oxide include oxides, nitrides or oxynitrides of Si, Al, Mg, In, Ni, Sn, Zn, Ti, Cu, Ce, Ta, or the like; and so on. Above all, for the purpose of making both high barrier properties and high transparency compatible with each other, it is preferable that the inorganic barrier layer contains aluminum oxide or silicon oxide, and in particular, from the viewpoints of moisture transmission and light beam transmitting properties, it is preferable that the inorganic barrier layer contains silicon oxide. In the case of constituting the inorganic barrier layer by using two or more kinds of metal oxides, it is desirable that the inorganic barrier layer contains aluminum oxide and silicon oxide as the metal oxide.

Although a ratio of the metal atom and the oxygen atom in each material is arbitrary, in order to enhance the transparency of the inorganic barrier layer, thereby preventing coloration from occurring, it is desirable that a ratio of the oxygen atom is extremely smaller than a stoichiometric ratio of the oxide. On the other hand, in order to enhance the denseness of the inorganic barrier layer to enhance the barrier properties, it is desirable that the ratio of the oxygen atom is small. From this viewpoint, for example, in the case of using $SiO_x$ as the metal oxide, a value of x is especially preferably from 1.5 to 1.8. Also, in the case of using $AlO_x$ as the metal oxide, a value of x is especially preferably from 1.0 to 1.4.

When a thickness of the inorganic barrier layer is increased, the barrier properties tend to be enhanced. However, in order that when bent, a crack may be hardly yielded to prevent the breakage from occurring, it is desirable to make the thickness thin. Then, an adequate thickness of the inorganic barrier layer is generally 5 nm or more, and preferably 10 nm or more, and generally not more than 1,000 nm, and preferably not more than 200 nm.

Although a film forming method of the inorganic barrier layer is not limited, the film formation can be generally carried out by means of a sputtering method, a vacuum vapor deposition method, an ion plating method, a plasma CVD method, or the like. For example, in the sputtering method, the inorganic barrier layer can be formed according to a reactive sputtering system with plasma using, as raw materials, one or plural kinds of metal targets and an oxygen gas.

• Polymer layer:

For the polymer layer, any polymers can be used, and for example, those capable of being subjected to film formation within a vacuum chamber can also be used. Incidentally, the polymer constituting the polymer layer may be used singly, or two or more kinds thereof may be used jointly in arbitrary combination and ratio.

As a compound capable of giving the foregoing polymer, for example, there are exemplified the following compounds. Incidentally, the monomer may be used singly, or two or more kinds thereof may be used jointly in arbitrary combination and ratio.

For example, there are exemplified siloxanes such as hexamethyldisiloxane and the like, and polysiloxanes are obtained as the polymer.

There are exemplified p-xylylenes such as di-p-xylylene and the like, and poly(p-xylylene)s are obtained as the polymer.

There are exemplified such monomers that two kinds of monomers can be subjected to addition polymerization alternately and repeatedly. According to this, poly-addition polymers are obtained, and examples thereof include polyurethane (diisocyanate/glycol), polyurea (diisocyanate/diamine), polythiourea (dithioisocyanate/diamine), polythioether urethane (bisethylene urethane/dithiol), polyimine (bisepoxy/primary amine), polypeptide amide (bisazolactone/diamine), polyamide (diolefin/diamide), and so on.

There are exemplified acrylate monomers. Although any monofunctional, bifunctional or polyfunctional acrylate monomers may be used, in order to obtain an adequate evaporation rate, degree of cure or curing rate, or the like, it is preferable to combine two or more kinds of the foregoing acrylate monomers and use them jointly. Examples of the monofunctional acrylate monomer include aliphatic acrylate monomers, alicyclic acrylate monomers, ether based acrylate monomers, cyclic ether based acrylate monomers, aromatic acrylate monomers, hydroxyl group-containing acrylate monomers, carboxyl group-containing acrylate monomers, and so on.

There are exemplified monomers from which photocation-curable polymers such as epoxy based or oxetane based polymers and the like are obtained.

There is exemplified vinyl acetate. Furthermore, by saponifying a polymer thereof, polyvinyl alcohol is obtained.

There are exemplified unsaturated carboxylic acids such as acrylic acid, methacrylic acid, ethacrylic acid, fumaric acid, maleic acid, itaconic acid, monomethyl maleate, monoethyl maleate, maleic anhydride, itaconic anhydride, and the like; and so on. Furthermore, copolymers thereof with ethylene can be constituted. Also, a mixture of these compounds or a mixture thereof with a glycidyl ether compound, and a mixture thereof with an epoxy compound can be used as the polymer.

On the occasion of forming a polymer by polymerizing the foregoing monomer(s), there are no limitations on the polymerization method of monomer(s). However, in general, the polymerization is carried out after coating or vapor depositing a monomer-containing composition to achieve the film formation. As an example of the polymerization method, when a thermal polymerization initiator is used, the polymerization is started by means of contact heating by a heater or the like; radiant heating with infrared rays, microwaves, or the like; or the like. Also, when a photopolymerization initiator is used, the polymerization is started upon irradiation with active energy rays. In the case of irradiating active energy rays, various light sources can be used, and for example, irradiation light by a mercury arc lamp, a xenon arc lamp, a fluorescent lamp, a carbon arc lamp, a tungsten-halogen radiant lamp, or sunlight; and the like can be used. Also, electron beam irradiation or atmospheric pressure plasma treatment can be carried out.

Examples of a forming method of the polymer layer include a coating method, a vacuum film forming method, and so on.

In the case of forming the polymer layer by a coating method, for example, a method such as roll coating, gravure coating, knife coating, dip coating, curtain flow coating, spray coating, bar coating, and the like can be adopted.

Meanwhile, in the case of forming the polymer layer by a vacuum film forming method, there are exemplified film forming methods such as vapor deposition, plasma CVD, and the like.

Although a thickness of the polymer layer is not particularly limited, it is generally 10 nm or more, and generally not more than 5,000 nm, preferably not more than 2,000 nm, and more preferably not more than 1,000 nm. By making the thickness of the polymer layer thick, the uniformity of the thickness is easily obtained, a structural defect of the inorganic barrier layer can be efficiently buried with the polymer layer, and the barrier properties tend to be enhanced. Also, by making the thickness of the polymer layer thin, a crack of the polymer layer itself by an external force such as bending and the like is hardly caused, and therefore, the barrier properties are enhanced. For that reason, it is desirable to determine the thickness of the polymer layer as a thickness at which both barrier properties and bending strength are made compatible with each other, from the foregoing range.

Among the foregoing descriptions, as the more suitable gas barrier film (D), for example, there are exemplified films obtained by subjecting a base material film such as polyethylene terephthalate (PET), polyethylene naphthalate (PEN), and the like to vacuum vapor deposition with an inorganic material, preferably $SiO_x$ or $SiO_xN_y$ by means of a vacuum film forming method; and so on. Namely, there are included the case where the gas barrier film (D) is a film including a thermoplastic resin and $SiO_x$ vacuum-deposited on the thermoplastic resin; and the like. (A value of x is especially preferably from 1.5 to 1.8, and y represents an integer.) $SiO_x$ or $SiO_xN_y$ is an inorganic material which does not absorb moisture or does not react with moisture, and which achieves a barrier performance by regulating the free volume, and a dense thin film obtained by film formation by means of a vacuum vapor deposition method or the like, especially an $SiO_x$ thin film is more preferable. In particular, a film made of a thermoplastic resin and provided with an $SiO_x$ thin film has higher barrier properties and is desirable.

In the case of an organic barrier material, the majority thereof is concerned with a case where the barrier properties are achieved mainly by the thickness of the barrier material while dissolving and diffusing a gas such as a water vapor and the like in the barrier material. In that case, in the case where a gas dissolution amount in the barrier material elevates with time to the neighborhood of a saturated solubility, the gas blocking in the organic semiconductor element cannot be achieved, and therefore, such is not preferable.

Incidentally, in the gas barrier film (D) in the present invention, the gas barrier performance is specified in terms of a water vapor transmission rate (namely, a barrier performance of water vapor). This is because not only the barrier of water vapor is one of the most important functions, but the barrier of water vapor is one of materials which are most difficultly blocked, namely are easy to transmit, among those which are generally problematic, such as gases, e.g., oxygen, etc., volatile components, and low-molecular weight components, e.g., alkalis, acids, etc.

Incidentally, the gas barrier film (D) may be formed of one kind of material or two or more kinds of materials. Also, although the gas barrier film (D) may be formed of a single-layer film, it may be a laminated film provided with two or more layers of films.

So far as the gas barrier film (D) is laminated in the order described in the present invention in such a manner that it covers the organic semiconductor element (B), thereby enabling one to protect the organic semiconductor element (B) from the moisture and oxygen, its forming position is not limited. However, it is characterized that the gas barrier film (D) is provided on the surface of the organic semiconductor element (B) opposite to the substrate. Also, the rear surface of the organic semiconductor element (B) against the substrate-placing surface (the surface on the opposite side to the light receiving surface) may be similarly covered with the gas barrier film (D). This is because in the organic semiconductor device, the front surface and rear surface thereof are frequently formed with a larger area than those of other faces.

Then, by sealing an edge part of the gas barrier film (D) with a sealing material and accommodating the solar cell element in a space surrounded by the gas barrier film (D) and the sealing material, it becomes possible to protect the organic semiconductor element (B) from damp and oxygen.

Incidentally, in the case where a rear surface protective sheet as described later has a gas barrier performance, the rear surface protective sheet may also work as the gas barrier film (D) depending upon an application.

<Anticorrosion layer (E)>

In the present invention, the anticorrosion layer (E) is an important layer constituting the organic semiconductor device. The anticorrosion layer (E) as referred to in the present invention is different from a filler.

Since at least a pair of electrodes or the substrate (A) provided with electrodes is present in the organic semiconductor element, the anticorrosion layer (E) is disposed between the electrode and the layer (C) containing a scavenger which absorbs at least one of moisture and oxygen, as located on the opposite side of the electrode to the organic semiconductor element (B). Namely, the anticorrosion layer (E) is not particularly limited so far as it is disposed in such a manner that the layer (C) containing a scavenger which absorbs at least one of moisture and oxygen does not come into direct contact with the electrode.

Specifically, since the diffusion of the scavenger which absorbs at least one of moisture and oxygen into the electrode causes corrosion of the electrode, it is preferable to dispose the anticorrosion layer (E) as disposed above.

Also, although the anticorrosion layer (E) may be configured of either a single layer or plural layers, in the case of plural layers, the characteristics of the anticorrosion layer (E) as described below are those which the plural layers exhibit as the whole of layers.

Incidentally, the anticorrosion layer (E) in the present invention exhibits the following characteristic of water vapor transmission rate (namely, excellent gas barrier properties).

A water vapor transmission rate Pe of the anticorrosion layer (E) in an environment at 40 °C and 90 % RH is in a relation of 15 $g/m^2/day \geq Pe > Pd$, and it is in a relation of preferably 5 $g/m^2/day \geq Pe > Pd$, more preferably 1 $g/m^2/day \geq Pe \geq Pd \times 5$, still more preferably 1 $g/m^2/day \geq Pe \geq Pd \times 10$, and most preferably 0.1 $g/m^2/day \geq Pe \geq Pd \times 10$. As the measurement method, the foregoing method is adopted.

In the case where the water vapor transmission rate Pe of the anticorrosion layer (E) is larger than such an upper limit, there is a concern that an alkali, an acid, or the like which is yielded through a reaction of moisture, oxygen and a scavenger which have leaked out from the layer (C) containing a scavenger which absorbs at least one of moisture and oxygen cannot be sufficiently blocked, so that the deterioration of the organic semiconductor element (B) cannot be prevented from occurring. Also, there is a concern that in a manufacturing process of the organic electronic device, the organic solvent, the low-molecular weight components and the like which have volatilized from the adhering agent, the pressure sensitive adhesive, etc. to be used in the process cannot be sufficiently blocked, thereby denaturing the layer (C) containing a scavenger which absorbs at least one of moisture and oxygen, and at least one of moisture and oxygen after being assembled into an organic electronic device cannot be sufficiently absorbed, so that the deterioration of the organic semiconductor element (B) cannot be prevented from occurring.

Also, in the case where the water vapor transmission rate Pe of the anticorrosion layer (E) is smaller than a lower limit specified from a relation with the water vapor transmission rate Pd of the gas barrier film (D), there is a concern that the anticorrosion layer cannot sufficiently absorb the moisture or oxygen which has invaded the inside of the organic semiconductor element after assembling an organic electronic device or retained during an assembling process, so that the deterioration of the organic semiconductor element (B) cannot be prevented from occurring. This is conspicuous in the case where Pd of the gas barrier film (D) is low for the purpose of aiming to realize a long life.

Incidentally, although a membrane or a film, or the like having gas barrier properties is used for the anticorrosion layer (E), taking into consideration simplicity or costs of the assembling process of an organic electronic device, a gas barrier film form is the most preferable. On the other hand, it is not preferable to form a film having gas barrier properties directly into the organic semiconductor element (B). In the case of forming the foregoing film by means of wet film formation, there is a concern that the solvent penetrates into the organic semiconductor layer (B0), thereby causing deterioration. In the case of forming the foregoing film by means of dry film formation accompanied with a vacuum process, different from a film process for sticking a film, since the process is a batch process, the production efficiency is conspicuously inferior. Also, there is a concern that the organic semiconductor element (B) is damaged by an internal stress of the film.

As one of preferred embodiments of the anticorrosion layer (E) satisfying the foregoing requirement for the water vapor transmission rate, it is preferable to incorporate an inorganic material film having been film formed by a vacuum film forming method as a layer. Of inorganic material films, an inorganic material film which does not absorb moisture or react with moisture and which achieves a barrier performance by controlling a free volume is more preferable. For example, there are exemplified $SiO_x$, $SiO_xN_y$, and so on (y is an integer, and x is from 1.5 to 2).

In the case of an organic barrier material, the majority thereof is concerned with a case where the barrier properties are achieved mainly by the thickness of the barrier material while dissolving and diffusing a gas such as a water vapor and the like in the barrier material. In that case, in the case where a gas dissolution amount in the barrier material elevates with time to the neighborhood of a saturated solubility, the gas blocking in the organic semiconductor element cannot be achieved, and therefore, such is not preferable.

Incidentally, in the anticorrosion layer (E), the gas barrier performance is specified in terms of a water vapor transmission rate (namely, a barrier performance of water vapor). This is because not only the barrier of water vapor is

one of the most important functions, but the barrier of water vapor is one of materials which are most difficultly blocked (easy to transmit), among those which are generally problematic, such as gases, e.g., oxygen, etc., volatile components, and low-molecular weight components, e.g., alkalis, acids, etc.

Also, as a more preferred embodiment, the anticorrosion layer (E) has an adhesive function. When the anticorrosion layer (E) has an adhesive function, the element and the scavenger which absorbs at least one of moisture and oxygen are fixed. There is no concern that at the time of device deformation by bending or the like, the scavenger is deviated to come into contact with the element electrode. Also, at the time of device manufacture, the anticorrosion layer (E), the layer (C) containing a scavenger, and the gas barrier film (D) are laminated on the substrate (A) and the organic semiconductor element (B). On that occasion, there is brought such an advantage that there is no concern that the scavenger is deviated to come into contact with the element electrode.

Also, as properties of the anticorrosion layer (E) itself, it is preferable that the anticorrosion layer (E) has alkali resistance.

The scavenger component reacts with moisture to possibly yield an alkali. In this respect, when the anticorrosion layer (E) does not have alkali resistance, there is a concern that the alkali penetrates, thereby corroding and deteriorating the electrode.

Also, it is preferable that an acid is not yielded from the anticorrosion layer (E). When the acid comes into contact with the electrode, it corrodes and deteriorates the electrode. In view of the fact that an acid is not yielded, there is brought such an advantage that the corrosion and deterioration are prevented from occurring. Examples of a material which yields an acid include acetic acid vinyl based resins such as an ethylene-vinyl acetate copolymer and the like.

Specifically, representative characteristics of the anticorrosion layer (E) other than the foregoing characteristics are mentioned below.

The oxygen transmission ability which is required for the anticorrosion layer (E) varies depending upon the organic semiconductor element (B). For example, in general, an oxygen transmission rate in a thickness of 100 $\mu$m in an environment at 25 °C per unit area (1 $m^2$) per day is preferably not more than 500 cc/$m^2$/day/atm, more preferably not more than 100 cc/$m^2$/day/atm, still more preferably not more than 10 cc/$m^2$/day/atm, and especially preferably not more than 1 cc/$m^2$/day/atm. When the oxygen barrier performance falls within such a range, the deterioration of the element to be caused due to oxygen can be suppressed. Also, in the case where the used scavenger absorbs oxygen, it is preferable that the oxygen transmission rate of the anticorrosion layer (E) is a value equal to or more than the oxygen transmission rate of the gas barrier film (D). In the case where the oxygen transmission rate of the anticorrosion layer (E) is lower than the oxygen transmission rate of the gas barrier film (D), the scavenger scavenges oxygen in a region outside the element sealing region, namely an external region of the gas barrier film (D), so that the original purpose of preventing the device deterioration from occurring is lost. Incidentally, the oxygen transmission rate can be measured by the foregoing method.

As the adhesive function, the anticorrosion layer (E) is required to have adhering ability to the element electrode and the layer (C) containing a scavenger. As a basis of the adhering ability, the adhering strength is 0.1 N/cm or more, preferably 0.4 N/cm or more, and more preferably 1 N/cm or more. When the adhesive function is lower than such a lower limit, there is a concern that the scavenger is easily deviated to come into contact with the element electrode, thereby causing electrode deterioration. Also, the adhering strength is preferably not more than 100 N/cm, and more preferably not more than 50 N/cm.

Although the measurement of the adhering strength is described later, the adhering strength can be obtained by carrying out the determination of peel strength of adhered assembles in conformity with JIS K6854. A 180 degree-peel test, a 90 degree-peel test, or a T-peel test can be properly chosen depending upon a shape of a specimen.

Also, as an index of the alkali resistance, it is preferable that the anticorrosion layer (E) endures a test in conformity with ASTM D543. Specifically, it is preferable that after dipping in a 1 % sodium hydroxide solution for 24 hours, anything unusual is not observed in the appearance, and a dimensional change is not more than 5 %, and preferably not more than 1 %.

In general, a coefficient of water absorption of the anticorrosion layer (E) is preferably from 0.005 to 1 %, more preferably from 0.01 to 0.5 %, and still more preferably from 0.02 to 0.3 %. When the coefficient of water absorption exceeds such an upper limit, there is a concern that the alkali diffusion to be caused due to the absorbed moisture is promoted, so that an effect for preventing the electrode corrosion is deteriorated. On the other hand, when the coefficient of water absorption is less than such a lower limit, there is a concern that the moisture at the interface between the element electrode and the anticorrosion layer (E) is blocked by the anticorrosion layer (E), so that the moisture cannot be absorbed by the scavenger.

Also, in the case where the anticorrosion layer (E) is used on the light receiving surface side of the organic thin film solar cell element, a material capable of transmitting visible light therethrough is preferable from the viewpoint of not disturbing the light absorption. For example, a light transmittance to visible light (wavelength: 360 to 830 nm) is generally 75 % or more, preferably 80 % or more, more preferably 85 % or more, still more preferably 90 % or more, yet still more preferably 95 % or more, and especially preferably 97 % or more excluding a loss to be caused by partial

reflection at the film interface. This is because sunlight is more likely converted into electrical energy.

On the other hand, in the case where the anticorrosion layer (E) is used on the opposite side to the light receiving surface of the organic thin film solar cell element, the anticorrosion layer (E) is not always required to transmit visible light therethrough, and therefore, it may be opaque.

Furthermore, since the organic semiconductor device is frequently heated upon receiving light, it is preferable that the anticorrosion layer (E) has resistance to heat. From this viewpoint, a melting point of a constituent material thereof is generally 100 °C or higher, preferably 120 °C or higher, and more preferably 130 °C or higher, and generally not higher than 350 °C, preferably not higher than 320 °C, and still more preferably not higher than 300 °C. Also, a glass transition temperature thereof is generally 0 °C or higher, preferably 30 °C or higher, and more preferably 60 °C, and generally not higher than 300 °C, preferably not higher than 200 °C, and more preferably not higher than 160 °C. By using a material having a high melting point and a high glass transition temperature, it is possible to make the heat resistance satisfactory, and at the time of using the device, fusion and deterioration can be prevented from occurring.

A material constituting the anticorrosion layer (E) in the present invention is arbitrary so far as it has the foregoing characteristics. Specifically, examples of such a material include polyethylene based resins, polypropylene based resins, cyclic polyolefin based resins, α-olefin maleic anhydride copolymers, polystyrene based resins, acrylonitrile-styrene copolymers (AS resins), styrene-butadiene copolymers (SB resins), acrylonitrile-butadiene-styrene copolymers (ABS resins), polyvinyl chloride based resins, polyvinylidene chloride based resins, polyvinyl acetate based resins, polyvinyl alcohol based resins, ethylene-vinyl alcohol copolymers, polyvinyl butyral based resins, polyvinyl pyrrolidone based resins, fluorine based resins, poly(meth)acrylic resins, polycarbonate based resins, polyester based resins such as polyethylene terephthalate, polyethylene naphthalate, and the like, polyimide based resins, polyamide-imide based resins, polyaryl phthalate based resins, polyamide based resins, silicone based resins, polysulfone based resins, polyether sulfone based resins, polyphenylene sulfide based resins, polyurethane based resins, polybenzoimidazole based resins, phenol based resins, melamine based resins, urea resins, resorcinol based resins, xylene based resins, epoxy based resins, acetal based resins, cellulose based resins, and so on. Of these, resin materials such as polyethylene based resins, cyclic polyolefin based resins, ethylene-vinyl acetate copolymers, fluorine based resins, poly(meth)acrylic resins, polycarbonate based resins, polyester based resins, polyimide based resins, epoxy resins, and the like are preferable, with polyethylene based resin, fluorine based resins, poly(meth)acrylic resins, polyester based resins, polyimide based resins, and epoxy based resins being more preferable. Above all, poly(meth)acrylic resins and epoxy based resins are especially preferable from the standpoint that they are able to impart an adhesive function.

This anticorrosion layer (E) may be configured of a single layer, and it may also be configured of plural layers. In the case of plural layers, a combination of a polyester based resin and a poly(meth)acrylic resin, or a combination of a polyester based resin and an epoxy based resin is preferable from the standpoint that not only both transparency and heat resistance can be revealed, but an adhesive function can be imparted.

A thickness of the anticorrosion layer (E) per layer is generally 20 μm or more, and preferably 30 μm or more. Also, an upper limit thereof is 500 μm, more preferably not more than 200 μm, and still more preferably not more than 100 μm. When the thickness of the anticorrosion layer (E) exceeds the upper limit, in a flexible organic electronic device, the thickness increases, so that it becomes difficult to bend the device. Also, since the anticorrosion layer (E) is distant from the metal electrode of the element, there is a concern that the scavenger cannot efficiently absorb moisture or oxygen or the like which has reached the surroundings of the metal electrode. On the other hand, when the thickness of the anticorrosion layer (E) is lower than the lower limit, there is a concern that the suppression of the alkali diffusion becomes insufficient, so that the deterioration of the electrode cannot be prevented from occurring.

Also, in addition to the foregoing positions, this anticorrosion layer (E) may be disposed in a laminated state on the gas barrier film (D) in a portion on the substrate (A) where the organic semiconductor element (B) is not present.

Although the anticorrosion layer (E) can be formed by an arbitrary method according to the type of the compound to be used, for example, a method of fabricating a film or a sheet, such as a melt extrusion molding method, a solution casting method, a calendering method, and the like; or a wet film forming method of forming a solution constituting the anticorrosion layer (E) into a coated film by means of roll coating, gravure coating, knife coating, dip coating, curtain flow coating, spray coating, bar coating, die coating, spin coating or inkjetting, or by using a dispenser, or other means can be adopted.

Also, a dry film forming method such as plasma CVD, vacuum vapor deposition, ion plating, sputtering, and the like may be adopted.

Furthermore, after the film or sheet fabrication, and after the film formation, a polymerization, crosslinking or curing reaction may be carried out by heating by a heater, infrared rays, microwaves, or the like, or upon irradiation with ultraviolet light and/or visible light.

<Other layers (interlayers)>

In the present invention, other layers are those different from the members described in (A) to (F) unless

otherwise restricted.

[Sealing material]

In the present invention, a sealing material is a layer which is used in the case where the substrate (A) and the gas barrier film (D) are adhered to each other via an interlayer (other layer), or in the case where the gas barrier film (D) and the resin layer (F) are adhered to each other via an interlayer in such a manner that the resin layer (F) does not come into contact with the outside air, or the like.

The sealing material is a member for sealing an edge part of a laminate which is configured in the present invention, thereby sealing a space covered by these films in such a manner that moisture and oxygen do not invade the space. In the present invention, the sealing material is a member which is preferable in adhering layers such as the layer (C) containing a scavenger, the anticorrosion layer (E), the resin layer (F), and the like, films such as the gas barrier film (D) and the like, and the substrate (A) to each other.

As to a degree of water vapor transmittance which is required for the sealing material, a water vapor transmission rate in a thickness of 100 μm in an environment at 40 °C and 90 % RH per unit area (1 $m^2$) per day is preferably not more than 500 g/$m^2$/day, more preferably not more than 100 g/$m^2$/day, still more preferably not more than 30 g/$m^2$/day, yet still more preferably not more than 10 g/$m^2$/day, and especially preferably not more than 1 g/$m^2$/day. By applying such a sealing material, it becomes possible to suppress the transmission of moisture from the edge part of the laminate and to actuate the organic electronic device over a long period of time.

As a basis of the adhering ability of the sealing material to a material to be adhered, the adhering strength is 2 N/mm or more, preferably 4 N/mm or more, and more preferably 10 N/mm or more. When the adhering ability is lower than such a lower limit, there is a concern that the separation easily occurs, and moisture and oxygen invade, thereby causing deterioration of the organic electronic device.

Furthermore, since the organic semiconductor device is frequently heated upon receiving light, it is preferable that the sealing material also has resistance to heat. From this viewpoint, a melting point of a constituent material of the sealing material is generally 100 °C or higher, preferably 120 °C or higher, and more preferably 130 °C or higher, and generally not higher than 350 °C, preferably not higher than 300 °C, and still more preferably not higher than 280 °C. When the melting point is too low, there is a possibility that the sealing material is melted at the time of using the organic electronic device.

Examples of a material constituting the sealing material include polymers such as fluorine based resins, silicone based resins, acrylic resins, α-olefin maleic anhydride copolymers, urethane based resins, cellulose based resins, vinyl acetate based resins, ethylene-vinyl acetate copolymers, epoxy based resins, vinyl chloride based resins, phenol based resins, melamine based resins, urea resins, resorcinol based resins, polyamide based resins, polyimide based resins, polystyrene resins, polyvinyl butyral based resins, polybenzoimidazole based resins, chloroprene rubbers, nitrile rubbers, styrene butadiene copolymers, and the like.

Incidentally, the sealing material may be made of a single kind of material or two or more kinds of materials.

The sealing material is provided at a position at which at least an edge part of the gas barrier film (D) can be sealed. According to this, a space surrounded by at least the gas barrier film (D) and the sealing material is hermetically sealed, thereby making it possible to inhibit moisture and oxygen from invasion into this space.

The sealing material is disposed in a width of generally from 0.5 to 100 mm, preferably from 1 to 80 mm, more preferably from 2 to 50 mm, and most preferably from 3 to 10 mm in the periphery of the substrate (A) in such a manner that the organic semiconductor element (B) is located in the inside of a hollow square-shaped type thereof. The sealing material is disposed in a thickness of generally from 5 μm to 1 mm, preferably from 10 μm to 100 μm and more preferably from 20 to 50 μm in such a manner that the organic semiconductor element (B) is located in the inside of a hollow square-shaped type thereof. The sealing material is required to fill irregularities of the substrate or the film or sheet to be stuck thereon and to have a thickness and a width for sufficiently protecting the inside from water vapor or oxygen. However, when the width is too wide, the effective area decreases, whereas when the thickness is too thick, the transmission amount of water vapor or oxygen becomes large. Thus, the foregoing ranges are adequate.

In that case, the sealing material is not particularly limited on the adhering form so far as it is able to adhere the substrate (A) and the gas barrier film (D) to each other without leaving a gap. Examples of the adhering form include adhering by curing with a sealing agent, adhesion by volatilization of a solvent/dispersing medium, hot melting, adhering (pressure sensitive adhesion) by means of mere sticking, and so on. From the viewpoint of making the manufacture easier, pressure sensitive adhesion by means of mere sticking is preferable. Also, since a network by curing makes the gas barrier properties satisfactory, in the case where the sealing material is required to have barrier properties, adhering by curing is preferable.

Examples of the curing method include curing by a chemical reaction at ordinary temperature, heat curing, photocuring with visible light or ultraviolet rays, electron beam curing, anaerobic curing, and so on. Above all, from the viewpoint of the fact that the curing control can be precisely carried out, it is preferable to carry out heat curing or curing

with ultraviolet rays.

Also, as properties of the sealing material, a liquid form, a gel form, a sheet form, and the like are properly chosen depending upon the adhering method. From the viewpoint of preventing a problem of liquid dripping from occurring in a sealing process, a sheet form is preferable.

[Encapsulant]

In the present invention, for the purpose of reinforcing the organic electronic device, or other purposes, an encapsulant may be used.

From the viewpoint of keeping the strength of the organic electronic device, it is preferable that the encapsulant has high strength. A specific strength cannot be unequivocally specified because it is also related to the strength of a weather resistant protective sheet or a rear surface protective sheet other than the encapsulant. However, it is desirable that the whole of the organic electronic device has satisfactory bending processability and has such strength that the separation of a bent portion does not occur.

Also, in the case where the encapsulant is used on the light receiving surface side of the organic thin film solar cell element, a material capable of transmitting visible light therethrough is preferable from the viewpoint of not disturbing the light absorption. For example, a light transmittance to visible light (wavelength: 360 to 830 nm) is generally 75 % or more, preferably 80 % or more, more preferably 85 % or more, still more preferably 90 % or more, yet still more preferably 95 % or more, and especially preferably 97 % or more. This is because sunlight is more likely converted into electrical energy.

On the other hand, in the case where the encapsulant is used on the opposite side to the light receiving surface of the organic thin film solar cell element, the encapsulant is not always required to transmit visible light therethrough, and therefore, it may be opaque.

Furthermore, since the organic semiconductor device is frequently heated upon receiving light, it is preferable that the encapsulant has resistance to heat. From this viewpoint, a melting point of a constituent material of the encapsulant is generally 100 °C or higher, preferably 120 °C or higher, and more preferably 130 °C or higher, and generally not higher than 350 °C, preferably not higher than 320 °C, and still more preferably not higher than 300 °C. By making the melting point high, at the time of using the organic semiconductor device, fusion and deterioration of the encapsulant can be prevented from occurring.

Although a thickness of the encapsulant is not particularly specified, it is generally 100 μm or more, preferably 150 μm or more, and more preferably 200 μm or more, and generally not more than 1,000 μm, preferably not more than 800 μm, and more preferably not more than 600 μm. By making the thickness thick, the strength of the whole of the organic semiconductor device tends to increase, whereas by making the thickness thin, the flexibility tends to increase, and the transmittance to visible light tends to be enhanced. For that reason, it is desirable to set up a range where the both advantages are revealed to the foregoing range.

As a material constituting the encapsulant, for example, a film made of an ethylene-vinyl acetate copolymer (EVA) resin composition (EVA film) and the like can be used.

However, since it relatively takes a lot of time for the crosslinking treatment of the EVA resin, there may be the case of causing lowering of the production speed and production efficiency of the organic semiconductor device. Also, during the long-term use, there may be the case where the vinyl acetate group which a decomposed gas (acetic acid gas) of the EVA resin composition or the EVA resin itself has adversely affects the organic semiconductor element, thereby lowering the power generation efficiency. Then, besides the EVA film, a film of a copolymer made of a propylene/ethylene/α-olefin copolymer can also be used as the encapsulant.

Incidentally, the encapsulant may be made of a single kind of material or two or more kinds of materials. Also, although the encapsulant may be formed of a single-layer film, it may also be a laminated film provided with two or more layers of films.

Although a position at which the encapsulant is provided is not limited, in order to surely protect it, the encapsulant is generally provided so as to interpose the solar cell element.

Also, a function such as ultraviolet ray blocking, heat ray blocking, electrical conductivity, antireflection, antiglare properties, light diffusion, light scattering, wavelength conversion, gas barrier properties, and the like may be imparted to the encapsulant. In particular, in the case of a solar cell, in view of the fact that it is exposed to strong ultraviolet rays from sunlight, it is preferable that the encapsulant has an ultraviolet ray blocking function.

As a method of imparting such a function, a layer having the function may be laminated on an encapsulant by means of coating film formation or the like, or a material capable of revealing the function may be incorporated into the encapsulant by means of dissolution and dispersion or the like.

[Weather resistant protective sheet]

The weather resistant protective sheet is a sheet or film for protecting the organic electronic device from the device installation environment such as temperature change, humidity change, light, wind and rain, and the like. By covering the device surface with the weather resistant protective sheet, there is brought such an advantage that the organic electronic device constituent material, particularly the organic semiconductor element (B) is protected, and high power generation ability can be obtained without causing the deterioration.

Since the weather resistant protective sheet is positioned at the most superficial layer of the organic semiconductor element (B), it is preferable that the weather resistant protective sheet is provided with suitable performances as a surface covering material of the organic semiconductor element (B), such as weather resistance, heat resistance, transparency, water repellency, anti-fouling properties, mechanical strength, and the like and also has such properties that when exposed outdoors, it has keep such functions over a long period of time.

Also, in the case where the weather resistant protective sheet is used on the light receiving surface side of the organic thin film solar cell element, a material capable of transmitting visible light therethrough is preferable from the viewpoint of not disturbing the light absorption. For example, a light transmittance to visible light (wavelength: 360 to 830 nm) is generally 75 % or more, preferably 80 % or more, more preferably 85 % or more, still more preferably 90 % or more, yet still more preferably 95 % or more, and especially preferably 97 % or more. This is because sunlight is more likely converted into electrical energy.

On the other hand, in the case where the weather resistance protective sheet is used on the opposite side to the light receiving surface of the organic thin film solar cell element, the weather resistance protective sheet is not always required to transmit visible light therethrough, and therefore, it may be opaque.

Furthermore, since the organic semiconductor element (B) is frequently heated upon receiving light, it is preferable that the weather resistance protective sheet has resistance to heat. From this viewpoint, a melting point of a constituent material of the weather resistance protective sheet is generally 100 °C or higher, preferably 120 °C or higher, and more preferably 130 °C or higher, and generally not higher than 350 °C, preferably not higher than 320 °C, and still more preferably not higher than 300 °C. By making the melting point high, at the time of using the organic semiconductor element (B), a possibility of occurrence of fusion and deterioration of the weather resistance protective sheet can be reduced.

The material constituting the weather resistant protective sheet is arbitrary so far as it is able to protect the organic electronic device. Examples of such a material include polyethylene resins, polypropylene resins, cyclic polyolefin resins, AS (acrylonitrile-styrene) resins, ASB (acrylonitrile-butadiene-styrene) resins, polyvinyl chloride resins, fluorine based resins, polyester resins such as polyethylene terephthalate, polyethylene naphthalate, and the like, phenol resins, polyacrylic resins, polyamide resins such as various nylons and the like, polyimide resins, polyamide-imide resins, polyurethane resins, cellulose based resins, silicone based resins, polycarbonate resins, and so on.

Above all, fluorine based resins are preferable. Specific examples thereof include polytetrafluoroethylene (PTFE), a 4-fluoroethylene-perchloroalkoxy copolymer (PFA), a 4-fluoroethylene-6-fluoropropylene copolymer (FEP), a 2-ethylene-4-fluoroethylene copolymer (ETFE), poly-3-fluorochloroethylene (PCTFE), polyvinylidene fluoride (PVDF), polyvinyl fluoride (PVF), and so on.

Incidentally, the weather resistant protective sheet may be made of a single kind of material or two or more kinds of materials. Also, although the weather resistant protective sheet may be formed of a single-layer film, it may also be a laminated film provided with two or more layers of films.

Although a thickness of the weather resistant protective sheet is not particularly specified, it is generally 10 μm or more, preferably 15 μm or more, and more preferably 20 μm or more, and generally not more than 200 μm, preferably not more than 180 μm, and more preferably not more than 150 μm. By making the thickness thick, the mechanical strength tends to increase, whereas by making the thickness thin, the flexibility tends to increase. For that reason, it is desirable to set up a range where the both advantages are revealed to the foregoing range.

Also, the weather resistance protective sheet may be subjected to a surface treatment such as a corona treatment, a plasma treatment, and the like for the purpose of improving adhering properties to other films.

It is preferable that in the organic electronic device, the weather resistant protective film is provided outwardly as far as possible. This is because more device constituent members can be protected.

Also, a function such as ultraviolet ray blocking, heat ray blocking, anti-fouling properties, hydrophilicity, hydrophobicity, fog resistance, scuff resistance, electrical conductivity, antireflection, antiglare properties, light diffusion, light scattering, wavelength conversion, gas barrier properties, and the like may be imparted to the weather resistant protective sheet. In particular, in the case of a solar cell, in view of the fact that it is exposed to strong ultraviolet rays from sunlight, it is preferable that the weather resistant protective sheet has an ultraviolet ray blocking function.

As a method of imparting such a function, a layer having the function may be laminated on the weather resistant protective sheet by means of coating film formation or the like, or a material capable of revealing the function may be incorporated into the weather resistant protective sheet by means of dissolution and dispersion or the like.

[Rear surface protective sheet]

The rear surface protective sheet is the same sheet or film as the foregoing weather resistant protective sheet, and the same material as that in the weather resistant protective sheet, except that the position is different, can be used. Also, when this rear surface protective sheet hardly transmits water and oxygen, it is possible to allow the rear surface protective sheet to function as a gas barrier layer.

Also, since the constituent member on the back side relative to the solar cell element is not always required to transmit visible light therethrough, a material which does not transmit visible light therethrough can also be used. For that reason, as the rear surface protective sheet, the following examples are exemplified.

As the rear surface protective sheet, films and sheets of various resins which are excellent in strength and also excellent in weather resistance, heat resistance, waterproofness, and light resistance can be used. For example, there can be used sheets of various resins inclusive of polyethylene based resins, polypropylene based resins, cyclic polyolefin based resins, polystyrene based resins, acrylonitrile-styrene copolymers (AS resins), acrylonitrile-butadiene-styrene copolymers (ABS resins), polyvinyl chloride based resins, fluorine based resins, poly(meth)acrylic resins, polycarbonate based resins, polyester resins such as polyethylene terephthalate, polyethylene naphthalate, and the like, polyamide based resins such as various nylons and the like, polyimide based resins, polyamide-imide based resins, polyaryl phthalate based resins, silicone based resins, polysulfone based resins, polyphenylene sulfide based resins, polyether sulfone based resins, polyurethane based resins, acetal based resins, cellulose based resins, and others can be used. Of these sheets of resins, sheets of a fluorine based resin such as polytetrafluoroethylene (PTFE), polyvinylidene fluoride (PVDF), polyvinyl fluoride (PVF), a copolymer of tetrafluoroethylene and ethylene or propylene (ETFE), and the like, a cyclic polyolefin based resin, a polycarbonate based resin, a poly(meth)acrylic resin, a polyamide based resin, and a polyester based resin are preferably used. Incidentally, such a material may be used singly, or two or more kinds thereof may be used jointly in arbitrary combination and ratio.

As the rear surface protective sheet, a metal material can also be used. Examples thereof include aluminum foils and plates, stainless steel-made thin films, steel plates, and so on. It is preferable that such a metal material is subjected to corrosion inhibition. Incidentally, a metal which is used for this metal material may be used singly, or two or more kinds thereof may be used jointly in arbitrary combination and ratio.

Furthermore, a composite material of a resin and a metal can be used. For example, a sheet having high waterproofness in which a fluorine based resin film is adhered to the both surfaces of an aluminum foil may also be used. Examples of the fluorine based resin include monofluoroethylene based resin (a trade name: Tedlar, manufactured by Du Pont), polytetrafluoroethylene (PTFE), a copolymer of tetrafluoroethylene and ethylene or propylene (ETFE), a vinylidene fluoride based resin (PVDF), a vinyl fluoride based resin (PVF), and so on. Incidentally, the fluorine based resin may be used singly, or two or more kinds thereof may be used jointly in arbitrary combination and ratio.

Also, a function such as ultraviolet ray blocking, heat ray blocking, anti-fouling properties, hydrophilicity, hydrophobicity, fog resistance, scuff resistance, electrical conductivity, antireflection, antiglare properties, light diffusion, light scattering, wavelength conversion, gas barrier properties, and the like may be imparted to the rear surface protective sheet. In particular, from the viewpoint of moistureproofness, it is preferable to provide a gas barrier layer made of an inorganic oxide vapor deposition layer.

A film thickness of the rear surface protective sheet is generally 20 $\mu$m or more, preferably 50 $\mu$m or more, and more preferably 100 $\mu$m or more. Also, it is generally not more than 1,000 $\mu$m, preferably not more than 500 $\mu$m, and more preferably not more than 300 $\mu$m.

<Manufacturing method of organic electronic device (device forming process)>

Although a manufacturing method of the organic electronic device of the present embodiment is not limited, the order of lamination is important in the present invention. Specifically, in the organic electronic device in which the substrate (A), the organic semiconductor element (B), the layer (C) containing a scavenger which absorbs at least one of moisture and oxygen, and the gas barrier film (D) for covering the organic semiconductor element are laminated in this order, the organic electronic device is manufactured in such a manner that the organic semiconductor element (B) is manufactured so as to be provided with at least a pair of electrodes, and one layer or plural layers of the anticorrosion layer (E) are laminated between the electrode located on the opposite side to the substrate and the layer (C) containing a scavenger which absorbs at least one of moisture and oxygen.

Preferably, the following manufacturing procedures are exemplified.

Step 1: To provide the substrate (A) with the organic semiconductor element (B) in which one or two or more of the organic semiconductor elements (B) are connected in series or in parallel.

Step 2: To manufacture a laminate having one layer or plural layers of the anticorrosion layer (E) laminated on the layer (C) containing a scavenger which absorbs at least one of moisture and oxygen.

Step 3: To laminate the laminate of the layer (C) containing a scavenger and the anticorrosion layer (E) as

manufactured in Step 2 and the gas barrier film (D) on the organic semiconductor element (B) on the substrate (A) as manufactured in Step 1 in the order of at least the substrate (A), the organic semiconductor element (B), the anticorrosion layer (E), the layer (C) containing a scavenger and the gas barrier layer (D).

As preferred other manufacturing procedures, the following are exemplified.

Step 1: To provide the substrate (A) with the organic semiconductor element (B) in which one or two or more of the organic semiconductor elements (B) are connected in series or in parallel.

Step 2': To manufacture a laminate having the gas barrier film (D), the layer (C) containing a scavenger which absorbs at least one of moisture and oxygen, and one layer or plural layers of the anticorrosion layer (E) laminated thereon.

Step 3': To laminate the laminate of the gas barrier film (D), the layer (C) containing a scavenger and the anticorrosion layer (E) as manufactured in Step 2' on the organic semiconductor element (B) on the substrate (A) as manufactured in Step 1 in the order of at least the substrate (A), the organic semiconductor element (B), the anticorrosion layer (E), the layer (C) containing a scavenger and the gas barrier layer (D).

Also, although the manufacturing method of the organic electronic device of the present embodiment is not limited, in the present invention, the organic electronic device is manufactured so as to exhibit at least the following two characteristic structures.

(i) Between the organic semiconductor element (B) and the layer (C) containing a scavenger which absorbs at least one of moisture and oxygen, the organic semiconductor element (B) and the layer (C) which absorbs at least one of moisture and oxygen are disposed in such a manner that they do not come into contact with each other.

(ii) The substrate (A) and the gas barrier film (D) are adhered to each other directly or via an interlayer in such a manner that the organic semiconductor element (B) and the layer (C) which absorbs at least one of moisture and oxygen do not come into contact with the outside air.

As to (i), the reason why the organic semiconductor element (B) and the layer (C) are allowed to not come into direct contact with each other is described above.

As to (ii), the reason why the organic semiconductor element (B) and the layer (C) which absorbs at least one of moisture and oxygen are allowed to not come into contact with the outside air resides in the matter that when the organic semiconductor element (B) comes into contact with water vapor or oxygen in the outside air, an organic solvent, or a volatile component, particularly water vapor, there are caused inconveniences such as lowering of the efficiency, shortening of the life, and the like. The layer (C) containing a scavenger which absorbs at least one of moisture and oxygen has a function to absorb the foregoing water vapor or the like more quickly than the absorption of the foregoing water vapor or the like onto the organic semiconductor element, thereby protecting the organic semiconductor element. However, when it comes into contact the outside air, there is a concern that the layer (C) absorbs the foregoing water vapor or the like, and its absorbing ability is lowered, so that the layer (C) no longer achieves the foregoing function.

One of specific embodiments of the organic electronic device manufactured under such a condition is shown in Figs. 3 and 4. Fig. 3 is a sectional view, and Fig. 4 is an upper surface view. As a more preferred embodiment, the gas barrier film (D) and the resin layer (F) are disposed so as to be adhered to each other directly or via an interlayer in such a manner that the resin layer (F) does not come into contact with the outside air.

Namely, in order that the resin layer (F) may not come into contact with the outside air, the resin layer (F) is disposed in such a manner that it is not exposed to an end face of the organic electronic device. In this example, the resin layer (F) is configured of the anticorrosion layer (E) 5. For example, as shown in Figs. 3 and 4, in the organic electronic device in the present invention, from the structural standpoint, the gas barrier film (D) 7 is disposed more outside than the resin layer (F) configured of the anticorrosion layer (E) 5 in the end face of the organic electronic device. Then, the substrate (A) 1 and the gas barrier film (D) 7 are adhered to each other directly or via an interlayer. When the resin layer (F) reaches a adhering face at which the substrate (A) 1 and the gas barrier film (D) 7 are adhered to each other directly or via an interlayer (namely, an end part of the organic electronic device), the resin layer (F) is exposed to the outside. In the example shown in Figs. 3 and 4, the substrate (A) 1 and the gas barrier film (D) 7 are adhered to each other via the resin layer (F) composed of the anticorrosion layer (E) 5 and the layer (C) 6 containing a scavenger. For that reason, there may be an undesirable case where water vapor, oxygen, an organic solvent, a volatile component, or the like penetrates from the surface direction of the resin layer (F) and is brought into contact with or absorbed onto the organic semiconductor element (B) or the layer (C) 6 containing a scavenger which absorbs at least one of moisture or oxygen, thereby damaging it to cause a situation of lowering of the efficiency or life.

In this respect, by providing a non-illustrated gas barrier layer such as a rear surface protective sheet and the like on the organic semiconductor element side of the gas barrier film (D) 7 and also disposing the resin layer (F) in such a manner that it is not exposed to the outside without reaching an end face of the organic electronic device, the lowering of the efficiency or life can be effectively prevented from occurring.

Namely, in an example shown in a sectional view in Fig. 5, the layer (C) 6 containing a scavenger is formed on the gas barrier film (D) 7 in which a non-illustrated gas barrier layer such as a rear surface protective sheet and the

like is formed, and the resin layer (F) configured of the anticorrosion layer (E) 5 is disposed so as to cover this layer (C) 6 containing a scavenger. The resin layer (F) is adhered to the gas barrier film (D) 7 via the sealing material 8 in such a manner that it is not exposed to the outside without reaching an end face of this organic electronic device.

Also, the foregoing respective layers may be adhered to each other directly or via an interlayer.

Examples of a method of achieving direct adhering include a method in which after coating a photocuring resin, the respective layers are adhered to each other and cured upon irradiation with UV light, followed by heating for curing at, for example, about 80 °C for about 20 minutes; a method in which after coating a thermosetting resin, the respective layers are adhered to each other and heated for curing at, for example, about 120 °C for about one hour; and so on.

Also, in the case of allowing an interlayer to intervene, although the foregoing interlayer may be allowed to intervene, such an interlayer is preferably a layer containing a sealing material.

A more specific manufacturing method of an organic electronic device is exemplified below.

For example, the following manufacturing procedures are exemplified.

Step I: To provide the substrate (A) with the organic semiconductor element (B) in which one or two or more of the organic semiconductor elements (B) are connected in series or in parallel.

Step II: To manufacture a laminate having the resin layer (F), more preferably one layer or plural layers of the anticorrosion layer (E) (hereinafter referred to as the "resin layer (F)") laminated on the layer (C) containing a scavenger which absorbs at least one of moisture and oxygen. In that case, the layer (C) must be made to have an area smaller than that of the layer (F).

Step III: To laminate the laminate of the layer (C) containing a scavenger and the resin layer (F) as manufactured in Step II on the organic semiconductor element (B) on the substrate (A) as manufactured in Step I and the gas barrier film (D) in the order of at least the substrate (A), the organic semiconductor element (B), the resin layer (F), the layer (C) containing a scavenger and the gas barrier layer (D).

As preferred other manufacturing procedures, the following are exemplified.

Step I: To provide the substrate (A) with the organic semiconductor element (B) in which one or two or more of the organic semiconductor elements (B) are connected in series or in parallel.

Step II' : To manufacture a laminate having the gas barrier film (D), the layer (C) containing a scavenger which absorbs at least one of moisture and oxygen, and the resin layer (F) laminated thereon.

Step III': To laminate the laminate of the gas barrier film (D), the layer (C) containing a scavenger and the resin layer (F) as manufactured in Step II' on the organic semiconductor element (B) on the substrate (A) as manufactured in Step I in the order of at least the substrate (A), the organic semiconductor element (B), the resin layer (F), the layer (C) containing a scavenger and the gas barrier layer (D).

Also, with respect to other layers, for example, the foregoing encapsulant, weather resistant protective sheet and rear surface protective sheet, after previously manufacturing a laminate obtained by laminating such other layers on the substrate (A) and/or the gas barrier film (D), the foregoing Steps 1 to 3, 1 to 3', I to III, or I to III' may be carried out; or after the foregoing Steps 1 to 3, 1-3', I to III, or I to III', such other layers may be laminated on the substrate (A) and/or the gas barrier film (D).

With respect to the foregoing other layers, although the order is not particularly limited, in the case where the substrate (A) side is the light receiving surface, the order is preferably an order of the weather resistant protective sheet, the gas barrier film, the encapsulant, the substrate (A), the organic semiconductor element (B), the layer (C) containing a scavenger which absorbs at least one of moisture and oxygen, the gas barrier film (D), the encapsulant, and the rear surface protective sheet; or an order of the weather resistant protective sheet, the encapsulant, the gas barrier film, the substrate (A), the organic semiconductor element (B), the layer (C) containing a scavenger which absorbs at least one of moisture and oxygen, the gas barrier film (D), the encapsulant, and the rear surface protective sheet. In the case where the gas barrier film (D) is the light receiving surface, the order is preferably an order of the rear surface protective sheet, the encapsulant, the substrate (A), the organic semiconductor element (B), the layer (C) containing a scavenger which absorbs at least one of moisture and oxygen, the gas barrier film (D), the encapsulant, and the weather resistant protective sheet. Properly, if desired, each of the foregoing layers may be a laminate of plural layers or may be omitted, and other functional layer may be inserted.

A lamination method is not particularly limited so far as the effects of the present invention are not impaired. Examples thereof include lamination with a adhering agent, heat sealing by means of melt adhering, extrusion lamination, co-extrusion molding, a wet film forming method for achieving coating and film formation, lamination by a vacuum laminator, a heat sealing method by heating or by a heat press or the like, and a wet film forming method by means of coater coating. Above all, lamination with a photocuring adhering agent which is with a track record in organic EL device sealing, or a lamination method using a vacuum laminator which is with a track record in solar cells is preferable from the standpoint that general-purpose equipment can be used.

Although it is preferable that an edge part of the organic electronic device is sealed by the sealing material, there is no particular limitation on the layers to be adhered so far as the gas barrier properties can be kept. Examples of a combination to be adhered with a sealing agent include an edge part of any one pair, plural pairs or all layers of the

gas barrier film (D) and the substrate (A); when plural layers of gas barrier films are present, the gas barrier film and the gas barrier film; the gas barrier film (D) and the rear surface protective sheet; the substrate (A) and the weather resistant protective sheet; and the weather resistant protective sheet and the rear surface protective sheet. From the viewpoint of attaching importance to keeping of the gas barrier properties, edge part sealing of the gas barrier film and the substrate, or the gas barrier film and the gas barrier film is preferable; and from the viewpoint of increasing the strength of the whole of the device, the weather resistant protective sheet and the rear surface protective sheet and all layers are preferable.

A step of sealing an edge part with a sealing agent can be properly chosen depending upon the layers to be adhered, the kind of the sealing agent, or the like. For example, after laminating the organic electronic device constituent layers, sealing may be carried out, or at the time of laminating the constituent layers, sealing may be carried out at the same time. From the standpoint of simplifying the manufacturing process, it is preferable to carry out sealing simultaneously with the time of lamination.

<Manufacturing method of organic electronic device in mass production>

In order to efficiently manufacture the organic electronic device, as shown in a sectional view of Fig. 6 and a plan view of Fig. 7, a method in which an organic electronic device obtained by laminating a large number of organic semiconductor elements (B) 20 on the substrate (A) 1 having a large area, followed by lamination according to the layer configuration in the present invention is cut one by one is very effective from the standpoints of time, work and cost. Since the respective members are the same as those in the organic electronic device shown in Figs. 3 and 4, although descriptions thereof are omitted herein, the same members were given the same symbols.

Namely, from the viewpoints of manufacturing efficiency and cost reduction, it is preferable that after fabricating an organic device having a large area at once, the fabricated organic device is divided in a necessary size in accordance with an application and used. In particular, in an application for solar cell, there may be the case where a voltage necessary for the purpose is obtained as an electronic device in which cells having an appropriate size are connected in series. In that case, as described above, the productivity is more enhanced by manufacturing an organic solar cell by fabricating an organic device having a large area at once and then dividing it into cells having an appropriate size.

Taking into account convenience of such a manufacturing process, for example, as shown in Figs. 6 and 7, when the layer (C) 6 containing a scavenger which absorbs at least one of moisture and oxygen is divided in an appropriate size, and a boundary or end part thereof is adhered directly by the gas barrier film (D) 7 and the anticorrosion layer (E) 5, not only it is possible to achieve simplification of an assembling process and robustness of works, but the boundary portion is adhered. Therefore, the fabricated organic device sheet in a large area can be divided into individual cells through a cutting treatment in a usual atmosphere when oxygen or water vapor is present.

According to the cutting treatment, taking into account the matter that the size of the apparatus is liable to become large, the generation of swarf, workability, or the like, assembling of a manufacturing process in an environment where oxygen or water vapor is blocked is greatly disadvantageous from the standpoints of cost and work efficiency. What the cutting treatment can be achieved in a usual atmosphere is greatly advantageous as an industrial process.

Furthermore, since it is possible to store and transport the organic device in a usual atmosphere at a stage of the large-sized sheet before cutting, there is also brought such a great advantage that after storing or transporting an enormous amount of devices in a large-sized sheet state, the devices can be subjected to a cutting treatment at once in a convenient place.

Then, the organic electronic device of the present invention can be more efficiently mass-produced by further adding the following condition to the foregoing manufacturing method (described in the manufacturing method of organic electronic device).

Specifically, at least two or more of the organic semiconductor elements (B) are disposed while leaving a gap between each other on the substrate (A); the resin layer (F) is laminated on the at least two or more organic semiconductor elements (B); two or more of the layers (C) containing a scavenger which absorbs at least one of moisture and oxygen are disposed while leaving a gap between each other on the resin layer (F); and the gas barrier film (D) is laminated on the layer (C), following by cutting so as to contain the organic semiconductor element (B) and the layer (C) containing a scavenger which absorbs at least one of moisture and oxygen.

Preferably, the portion to be cut is a portion where at least the substrate (A) and the gas barrier film (D) are adhered to each other directly or via an interlayer.

More preferably, the portion to be cut is a portion where at least the substrate (A), the gas barrier film (D), and the resin layer (F) are laminated.

Then, still more preferably, the interlayer is a layer containing a sealing material. Above all, as shown in Figs. 4 and 5, the sealing material 8 is previously formed in a place to be cut, and cutting is carried out within the sealing material 8.

Namely, as to the manufacturing method of the present invention, it is preferred means of the manufacturing

method in the present invention to achieve cutting in such a manner that the organic semiconductor element (B) and the layer (C) containing a scavenger which absorbs at least one of moisture and oxygen do not come into contact with each other without being exposed to the outside air.

According to such a manufacturing method, cutting of the plural organic semiconductor elements disposed on the substrate into individual elements does not cause a problem in efficiency or life of the element even in a usual atmosphere but not in a dry nitrogen atmosphere and is suitable from the manufacturing standpoint. According to installation of a cutting device or internal cutting treatment in a dry nitrogen atmosphere, the volume for keeping the dry nitrogen atmosphere becomes large, or dusts or oil droplets are yielded, leading to an increase of costs and unpreferable tendency.

Incidentally, the peripheral sealing material of the organic semiconductor element after cutting into individual elements is disposed in a width of generally from 0.5 to 100 mm, preferably from 1 to 80 mm, more preferably from 2 to 50 mm, and most preferably from 3 to 10 mm in the periphery of the substrate after cutting in such a manner that the organic semiconductor element after cutting is located in the inside of the peripheral sealing material of a hollow square-shaped type. The sealing material is disposed in a thickness of generally from 5 $\mu$m to 1 mm, preferably from 10 $\mu$m to 100 $\mu$m and more preferably from 20 to 50 $\mu$m in such a manner that the organic semiconductor element (B) is located in the inside of a hollow square-shaped type thereof. The sealing material is required to fill irregularities of the substrate or the film or sheet to be stuck thereon and to have a thickness and a width for sufficiently protecting the inside from the water vapor or oxygen. However, when the width is too wide, the effective area decreases, and when the thickness is too thick, the transmission amount of the water vapor or oxygen becomes large. Thus, the foregoing ranges are adequate.

One of specific embodiments is shown in Figs. 6 and 7.

<Performance evaluation of organic electronic device>

The organic electronic device according to the present invention is characterized by having the following performances.

For example, in the case of an organic thin film solar cell, the performance can be evaluated by carrying out the following accelerated test and comparing a change in photoelectric conversion characteristic before and after the test.

<u>Evaluation method</u>

For the accelerated test, the organic electronic device is placed in a high-temperature, high-humidity environment in an environmental testing system (for example, SH-241, manufactured by ESPECT CORP.). The high-temperature, high-humidity environment is preferably set up at 40 °C and 90 % RH or at 85 °C and 85 % RH. Although a test period can be properly chosen depending upon the device constituent materials, it is preferable to carry out the test for 24 hours or more. Also, as to the photoelectric conversion characteristic, the organic thin film solar cell is irradiated with light of an AM 1.5 G condition at an irradiation intensity of 100 $mW/cm^2$ using a solar simulator, thereby measuring a current and a voltage. From a current/voltage curve obtained by such measurement, power conversion efficiency (PCE), short-circuit current, open-circuit voltage, FF (fill factor), series resistance, and shunt resistance can be determined.

As an expression for comparing the photoelectric conversion characteristic before and after the accelerated test, for example, the following is exemplified. Rate of change in PCE = (PCE after the accelerated test)/(PCE before the accelerate test)

Namely, as to the rate of change in the power conversion efficiency (PCE) of the organic electronic device according to the present invention, as defined by the foregoing expression, a value after the accelerated test is generally 0.86 or more, preferably 0.88 or more, and more preferably 0.90 or more relative to the initial performance.

In the organic electronic device according to the present invention, even when a load is applied, the layer (C) containing a scavenger and the element electrode do not come into contact with each other, and a performance with a high deterioration preventing effect is also revealed. As the evaluation, when the layer (C) containing a scavenger is pressed from the gas barrier film side toward the organic semiconductor element (B) direction, the presence or absence of contact may be confirmed.

The organic electronic device according to the present invention has satisfactory weather resistance. Even when an outdoor exposure test or a weather resistance test with a weathering testing instrument is carried out, the organic electronic device according to the present invention keeps the performance and exhibits high durability. It may be considered that this is because the electrode deterioration is suppressed by the presence of the anticorrosion layer. Also, in the case of laminating a weather resistant protective sheet, higher weather resistance is revealed.

EXAMPLES :

The present invention is more specifically described by reference to the Examples, but it should be construed

that the present invention is not limited to the following Examples so far as a gist thereof is not deviated.

[Measurement method]

• Water vapor transmission rate:

A water vapor transmission rate is obtained by the measurement using an apparatus equipped with a humidity sensor, an infrared sensor, and a gas chromatograph in conformity with JIS K7129 in an environment at 40 °C and 90 % by a dish method (JIS Z0208). In particular, in the case of high water vapor barrier properties, it is preferable to measure the water vapor transmission rate by an MOCON method with higher precision in conformity with JIS K7129B, and the water vapor transmission rate is measured using a water vapor transmission rate analyzer, PERMATRAN-W, manufactured by Mocon, Inc.

• Adhering strength:

The adhering strength is obtained by carrying out the determination of peel strength of adhered assembles in conformity with JIS K6854. A 180 degree-peel test, a 90 degree-peel test, or a T-peel test may be properly chosen depending upon a shape of a specimen. As a specific apparatus, there is exemplified a tensile tester, manufactured by Orientec Co., Ltd.

• Moisture absorptivity of scavenger:

A scavenger was allowed to stand for 15 minutes in an environment at 20 °C and 65 % RH, and a change in weight before and after the test was calculated.

[Example 1]

<Fabrication step of organic thin film solar cell element>

A material having an indium tin oxide (ITO) transparent electrically conductive film deposited on a glass substrate (sheet resistance: not more than 15 Ω/□) was subjected to patterning into a stripe of 2 mm in width by means of a usual photolithography technology and hydrochloric acid etching, thereby forming a transparent electrode. The patterned transparent electrode was successively washed by means of ultrasonic washing with a surfactant, water washing with ultrapure water, and ultrasonic washing with ultrapure water and then blown with nitrogen, followed by heat drying at 120 °C for 10 minutes.

Poly(ethylenedioxythiophene):poly(styrenesulfonic acid) (PEDOT:PSS, a trade name: Baytron PH, manufactured by H.C. Starck-V TECH Ltd.) that is an electrically conductive polymer was spin coated in a film thickness of 40 nm on this transparent substrate and then heat dried in the air at 120 °C for 10 minutes.

Since then, the substrate was carried in a glove box and operated in a nitrogen atmosphere.

First of all, the foregoing substrate was heat treated at 180 °C for 3 minutes in a nitrogen atmosphere.

A solution of 0.5 % by weight of the following compound (A) dissolved in a 1/2 mixed solvent (by weight) of chloroform/chlorobenzene was filtered and then spin coated on the foregoing PEDOT:PSS film at 1,500 rpm, followed by heating at 180 °C for 20 minutes, thereby obtaining a film of the following compound (B).

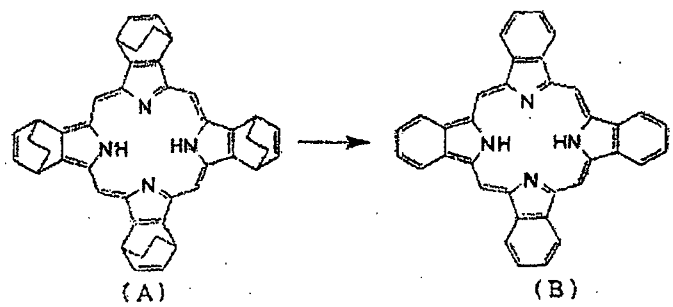

(A) (B)

A solution of 0.6 % by weight of the compound (A) that is a porphyrin compound, dissolved in a 1/1 mixed solvent (by weight) of chloroform/chlorobenzene and a solution of 1.4 % by weight of PCBNB (the following compound (C)), manufactured by Frontier Carbon Corporation, that is a fullerene derivative, dissolved therein were prepared and

mixed in a weight ratio of 1/1. After filtration, the mixture was spin coated on the film of the compound (B) that is the foregoing porphyrin compound, at 1,500 rpm, followed by heating at 180 °C for 20 minutes, thereby obtaining a mixed film of (B) and (C).

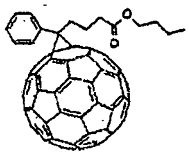

(C)

A solution of 1.2 % by weight of the compound (C) dissolved in toluene was filtered and then spin coated on the mixed film of the foregoing compounds (B) and (C) at 3,000 rpm, followed by heating at 65 °C. for 10 minutes, thereby obtaining a film of the compound (C).

Subsequently, the substrate in which a series of organic layers as described above had been film formed was brought into intimate contact with a shadow mask having a width of 2 mm so as to lie at right angles to the transparent electrode stripe and placed within a vacuum vapor deposition apparatus. Then, lithium fluoride (LiF) was vapor deposited in a film thickness of 0.5 nm at a vapor deposition rate of about 0.01 nm/sec on the organic layer. Subsequently, aluminum was vapor deposited in a film thickness of 80 nm at a vapor deposition rate of 0.2 nm/sec on the LiF layer, thereby forming a metal electrode.

There was thus obtained an organic thin film solar cell element having a light receiving surface portion of 2 mm × 2 mm in size.

<Device forming step>

On the metal electrode surface of the fabricated organic thin film semiconductor element, a getter sheet having a structure in which the layer (C) containing a scavenger and an adhesive sheet were laminated (HD-S05, manufactured by Dynic Corporation) was laminated via a film having a water vapor transmission rate of 1 $g/m^2$/day (Techbarrier, manufactured by Mitsubishi Plastic, Inc.). Here, the adhesive sheet and the foregoing film function as the anticorrosion layer (E) in view of the fact that they exist between the metal electrode 4 of the organic semiconductor element and the layer (C) containing a scavenger. Subsequently, a pressure sensitive adhesive double coated tape (J-7702, manufactured by Soken Chemical & Engineering Co., Ltd., thickness: 200 μm) which had been cut out in a hollow square shape was stuck as a sealing material to the periphery of the glass substrate in such a manner that the foregoing element was located in the inside of the hollow square shape. Furthermore, a gas barrier film having a water vapor transmission rate of $10^{-2}$ $g/m^2$/day (Techbarrier, manufactured by Mitsubishi Plastic, Inc.) was stuck so as to cover the element having the foregoing getter sheet and the foregoing film and the whole of the pressure sensitive adhesive double coated tape, thereby achieving element sealing.

There was thus obtained an organic thin film solar cell device having a structure in which the organic thin film solar cell element provided on the substrate was sealed by the upper surface barrier film (D) 7 and the sealing material made of the peripheral pressure sensitive adhesive double coated tape, and the organic semiconductor element (B) 20, the anticorrosion layer (E) 5 composed of an adhesive sheet, and the layer (C) 6 containing a scavenger were laminated in this order. This organic thin film solar cell device is shown in Fig. 1.

[Comparative Example 1]

<Fabrication of organic thin film solar cell element>

An organic thin film solar cell element was fabricated in the same manner as that in Example 1.

<Device forming step>

For sealing, the same getter sheet, gas barrier film 7 and pressure sensitive adhesive double coated tape as those in Example 1 are used. The getter sheet was adhered to the gas barrier film on the adhesive sheet surface. Similar to Example 1, the pressure sensitive adhesive double coated tape having been cut out in a hollow square shape was stuck to the periphery of the substrate, and the gas barrier film to which the getter sheet had been adhered was stuck so as to cover the element and the whole of the pressure sensitive adhesive double coated tape, thereby achieving element sealing.

By achieving sealing as in the present Comparative Example, the layer (C) 6 containing a scavenger was

pressed by the gas barrier film (D) 7 and came into contact with the metal electrode 4 of the organic semiconductor element (B) 20 constituting the organic thin film solar cell element. Namely, there was obtained an organic thin film solar cell having a structure in which although the organic thin film solar cell element provided on the substrate (A) 1 was sealed by the gas barrier film (D) 7 and the sealing material 8 made of the peripheral pressure sensitive adhesive double coated tape, the anticorrosion layer (E) 5 in which the organic semiconductor element (B) 20, the layer (C) 6 containing a scavenger, and an adhesive sheet 9 were laminated in this order did not exist. This organic thin film solar cell device is shown in Fig. 2.

The organic thin film solar cells fabricated in the Example and Comparative Example were subjected to performance evaluation in the following manners.

Each of the fabricated organic thin film solar cells was subjected to an accelerated test, and a change in photoelectric conversion characteristic before and after the test was compared. The accelerated test was carried out in an environment at 40 °C and 90 % RH for 24 hours using a small-sized environmental testing system (for example, SH-241, manufactured by ESPECT CORP.). Also, as to photoelectric convention characteristic values, the organic thin film solar cell was irradiated with light of an AM 1.5 G condition at an irradiation intensity of 100 mW/cm$^2$ using a solar simulator (manufactured by Bunkokeiki Co., Ltd.). From the obtained current/voltage curve, power conversion efficiency (PCE) was determined.

The performance evaluation results of the Example and Comparative Example are shown in Table 1. Here, a rate of change in PCE is defined as follows.

Rate of change in PCE = (PCE after the accelerated test)/(PCE before the accelerate test)

As demonstrated by the results shown in Table 1, it became clear that as compared with Comparative Example 1, Example 1 was small in the rate of change in PCE and small in the deterioration by the accelerated test and thus, provided an excellent organic thin film solar cell. It may be considered that an effect for suppressing the deterioration of the metal electrode was revealed by the presence of the anticorrosion layer between the metal electrode and the getter layer.

Also, the organic thin film solar cell in which the deterioration had proceeded was observed. As a result, in Comparative Example 1, a place of the metal electrode which had come into contact with the getter layer was deteriorated by an alkali and made transparent.

[Comparative Example 2]

An organic thin film solar cell element was fabricated in the same manner as that in Comparative Example 1, except for the following point, and then subjected to a performance evaluation experiment.

A gas barrier film having a water vapor transmission rate of $10^{-2}$ g/m$^2$/day (Techbarrier, manufactured by Mitsubishi Plastic, Inc.) was used as the gas barrier film (D) and the anticorrosion layer (E). Because of a high barrier performance of the anticorrosion layer (E), the layer (C) containing a scavenger which absorbs at least one of moisture and oxygen could not sufficiently scavenge water vapor or the like having attached to or invaded the organic semiconductor element during the assembling process, and the rate of change in PCE was found to be 0.70. The results are shown in Table 1.

[Comparative Example 3]

In Comparative Example 1, a 30 μm-thick EVA film (water vapor transmission rate: 20 g/m$^2$/day) having a VA content of 30 % was inserted as a filler between the layer (C) containing a scavenger which absorbs at least one of moisture and oxygen and the organic thin film solar cell element, and after assembling into an organic thin film solar cell device, the solar cell device was heated at 120 °C. for about 10 minutes and then brought into intimate contact with the electrode of the organic thin film solar cell element. A gas and a low-molecular weight component volatilized from the EVA film transmitted through pinholes of the electrode and damaged the organic thin film solar cell or an interface with the electrode. A rate of change in PCE was found to be 0.30. The results are shown in Table 1.

[Example 2]

<Fabrication step of organic thin film solar cell element>

A material having an indium tin oxide (ITO) transparent electrically conductive film deposited on a glass substrate

(sheet resistance: not more than IS Ω/□) was subjected to patterning into a stripe of 2 mm in width by means of a usual photolithography technology and hydrochloric acid etching, thereby forming a transparent electrode. The patterned transparent electrode was successively washed by means of ultrasonic washing with a surfactant, water washing with ultrapure water, and ultrasonic washing with ultrapure water and then blown with nitrogen, followed by heat drying at 120 °C for 10 minutes. A PEDOT-PSS (poly(ethylenedioxythiophene)-poly(styrenesulfonic acid)) solution was then coated on the formed transparent electrode 3 and dried at 120 °C for 10 minutes, thereby forming a hole transport layer having a film thickness of about 30 nm.

Furthermore, an organic semiconductor coating liquid was coated in a nitrogen atmosphere by a wire bar and dried at 150 °C for 10 minutes, thereby forming an organic semiconductor layer (remaining portion of the photoelectric conversion part) having a film thickness of about 100 nm on the hole transport layer. Incidentally, the actually used organic semiconductor coating liquid is a toluene solution of polythiophene (P3HT; poly-3-hexylthiophene) and an indene-added fullerene derivative.

Thereafter, an aluminum film having a film thickness of 80 nm was formed as an upper electrode layer on the organic semiconductor layer by means of a vapor deposition method.

<Device forming step>

A device forming step was carried out in the same manner as that in Example 1, except that a polypropylene film (Pylen P2002, manufactured by Toyobo Co., Ltd., thickness: 50 μm) was used as the anticorrosion layer (E).

There was thus obtained an organic thin film solar cell device having a structure in which the organic thin film solar cell element provided on the substrate was sealed by the upper surface barrier film (D) and the sealing material made of the peripheral pressure sensitive adhesive double coated tape, and the organic semiconductor element (B), the anticorrosion layer (E) composed of a polypropylene film, and the layer (C) containing a scavenger were laminated in this order.

[Comparative Example 4]

<Fabrication step of organic thin film solar cell element>

An organic thin film solar cell element was fabricated in the same manner as that in Example 2.

<Device forming step>

A device forming step was carried out in the same manner as that in Comparative Example 1.

By achieving sealing as in the present Comparative Example, the layer (C) containing a scavenger was pressed by the gas barrier film (D) and came into direct contact with the metal electrode of the organic thin film solar cell element. Namely, there was obtained an organic thin film solar cell having a structure in which although the organic thin film solar cell element provided on the substrate was sealed by the gas barrier film (D) and the sealing material made of the peripheral pressure sensitive adhesive double coated tape, the anticorrosion layer (E) in which the organic semiconductor element (B), the layer (C) containing a scavenger, and an adhesive sheet were laminated in this order did not exist.

Table 1

| | Gas barrier film | Anticorrosion layer | | | Scavenger | |
|---|---|---|---|---|---|---|
| | Water vapor transmission rate [g/m$^2$/day] | Water vapor transmission rate [g/m$^2$/day] | Film thickness [μm] | Adhering strength [N/cm] | Moisture absorbability [mg/cm$^2$] | Rate of change in PCE |
| Example 1 | $10^{-2}$ | 1 | 100 | 0 | 4 | 0.92 |
| Example 2 | $10^{-2}$ | 1 (PP) | 50 | 0 | 4 | 1.03 |
| Comparative Example 1 | $10^{-2}$ | No | - | 0 | 4 | 0.85 |
| Comparative Example 2 | $10^{-2}$ | $10^{-2}$ | 100 | 0 | 4 | 0.7 |
| Comparative Example 3 | $10^{-2}$ | 20 (EVA) | 200 | (*) | 4 | 0.3 |

(continued)

| | Gas barrier film | Anticorrosion layer | | | Scavenger | |
|---|---|---|---|---|---|---|
| | Water vapor transmission rate [g/m$^2$/day] | Water vapor transmission rate [g/m$^2$/day] | Film thickness [μm] | Adhering strength [N/cm] | Moisture absorbability [mg/cm$^2$] | Rate of change in PCE |
| Comparative Example 4 | $10^{-2}$ | No | | | 4 | 0.95 |
| (*): The measurement was impossible due to material breakage. | | | | | | |

[Example 3]

<Fabrication step of organic thin film solar cell element>

A material having an indium tin oxide (ITO) transparent electrically conductive film deposited on a glass substrate (sheet resistance: not more than 15 Ω/□) was subjected to patterning into a stripe of 2 mm in width by means of a usual photolithography technology and hydrochloric acid etching, thereby forming a transparent electrode. The patterned transparent electrode was successively washed by means of ultrasonic washing with a surfactant, water washing with ultrapure water, and ultrasonic washing with ultrapure water and then blown with nitrogen, followed by heat drying at 120 °C for 10 minutes.

Poly(ethylenedioxythiophene):poly(styrenesulfonic acid) (PEDOT:PSS, a trade name: Baytron PH, manufactured by H.C. Starck-V TECH Ltd.) that is an electrically conductive polymer was spin coated in a film thickness of 40 nm on this transparent substrate and then heat dried in the air at 120°C for 10 minutes.

Since then, the substrate was carried in a glove box and operated in a nitrogen atmosphere.

First of all, the foregoing substrate was heat treated at 180 °C for 3 minutes in a nitrogen atmosphere.

A solution of 0.5 % by weight of the foregoing compound (A) dissolved in a 1/2 mixed solvent (by weight) of chloroform/chlorobenzene was filtered and then spin coated on the foregoing PEDOT:PSS film at 1,500 rpm, followed by heating at 180 °C for 20 minutes, thereby obtaining a film of the foregoing compound (B).

A solution of 0.6 % by weight of the compound (A) that is a porphyrin compound, dissolved in a 1/1 mixed solvent (by weight) of chloroform/chlorobenzene and a solution of 1.4 % by weight of PCBNB (the foregoing compound (C)), manufactured by Frontier Carbon Corporation, that is a fullerene derivative, dissolved therein were prepared and mixed in a weight ratio of 1/1. After filtration, the mixture was spin coated on the film of the compound (B) that is the foregoing porphyrin compound, at 1,500 rpm, followed by heating at 180 °C for 20 minutes, thereby obtaining a mixed film of (B) and (C).

A solution of 1.2 % by weight of the compound (C) dissolved in toluene was filtered and then spin coated on the mixed film of the foregoing compounds (B) and (C) at 3,000 rpm, followed by heating at 65 °C for 10 minutes, thereby obtaining a film of the compound (C).

Subsequently, the substrate in which a series of organic layers as described above had been film formed was brought into intimate contact with a shadow mask having a width of 2 mm so as to lie at right angles to the transparent electrode stripe and placed within a vacuum vapor deposition apparatus. Then, lithium fluoride (LiF) was vapor deposited in a film thickness of 0.5 nm at a vapor deposition rate of about 0.01 nm/sec on the organic layer. Subsequently, aluminum was vapor deposited in a film thickness of 80 nm at a vapor deposition rate of 0.2 nm/sec on the LiF layer, thereby forming a metal electrode.

There was thus obtained an organic thin film solar cell element having a light receiving surface portion of 2 mm × 2 mm in size.

<Device forming step>

Operations were hereinafter carried out within a glove box purged with dry nitrogen. A getter sheet having a structure in which the layer (C) containing a scavenger and an adhesive sheet were laminated (HD-S07, manufactured by Dynic Corporation) was interposed by a film having a water vapor transmission rate (water vapor barrier performance) of $10^{-2}$ g/m$^2$/day (Techbarrier, manufactured by Mitsubishi Plastic, Inc.) and a film having a water vapor transmission rate of 1 g/m$^2$/day (another grade of Techbarrier, manufactured by Mitsubishi Plastic, Inc.). Here, the former film functions as the gas barrier film (D), and the latter film functions as the anticorrosion layer (E). Edge parts of the gas barrier film (D) and the anticorrosion layer (E) film were adhered to each other with a sealing material. The sealing material had a adhering line width of 3 mm and a adhering thickness of 20 μm. (* The laminate manufactured up to this stage is also

hereinafter referred to as "laminate (I)".)

Subsequently, a pressure sensitive adhesive double coated tape (J-7702, manufactured by Soken Chemical & Engineering Co., Ltd., thickness: 200 μm) which had been cut out in a hollow square shape was stuck as a adhering material to the periphery of the glass substrate in such a manner that the foregoing element was located in the inside of the hollow square shape.

A structure of this organic thin film solar cell device is shown in Figs. 3 and 4. On this pressure sensitive adhesive double coated tape, the sealing material 8 was stuck so as to cover the organic semiconductor layer located in the inside on the glass substrate constituting the substrate (A) 1 by the sheet in which the foregoing layer (C) 6 containing a scavenger had been interposed by the gas barrier film (D) 7 and the anticorrosion layer (E) 5, thereby achieving element sealing.

There was thus obtained an organic thin film solar cell device having a structure in which the organic semiconductor element (B) 20 that is the organic thin film solar cell element provided on the substrate was sealed by the upper surface barrier film (D) 7 and the sealing material 8 made of the peripheral pressure sensitive adhesive double coated tape, and the organic semiconductor element (B) 20, the anticorrosion layer (E) 5 composed of an adhesive sheet, and the layer (C) 6 containing a scavenger were laminated in this order. Incidentally, as to adhering between the barrier film (D) 7 and the anticorrosion layer (E) 5, whichever the adhering is achieved as shown in Fig. 3, or achieved as shown in Fig. 5 concerning the manufacture in the following Example 4, there is no problem so far as the necessary requirements are met. Incidentally, Fig. 4 is a view looking at the device in Fig. 3 from above.

[Example 4]

In Example 1, the laminate in the state of laminate (I) was taken out from the glove box and allowed to stand in the air at 25 °C and 60 % for 30 minutes. Thereafter, an organic thin film solar cell device was made on an experimental basis in exactly the same manner as that in Example 1, except that the resulting laminate was again returned into the glove box.

That is, after fabricating a laminated film having a structure of the laminate (I), so far as the time is short, it is possible to store the laminated film in the air, and it is possible to move the laminated film into the glove box through the air from a storage place in a nitrogen atmosphere. It can be considered that this is a great advantage in the case where in the manufacturing process of an organic semiconductor device, easiness of handling of the foregoing laminated film or robustness of the manufacturing process is taken into account.

[Example 5]

The device formation was carried out in the same manner as that in Example 4, except for the matter described below in the device forming step.

Operations were hereinafter carried out within a glove box purged with dry nitrogen. A getter sheet having a structure in which the layer (C) containing a scavenger and an adhesive sheet were laminated (HD-S07, manufactured by Dynic Corporation) was interposed by a film having a water vapor transmission rate (water vapor barrier performance) of $10^{-2}$ g/m$^2$/day (Techbarrier, manufactured by Mitsubishi Plastic, Inc.) and a film having a water vapor transmission rate of 1 g/m$^2$/day (another grade of Techbarrier, manufactured by Mitsubishi Plastic, Inc.). Here, the former film functions as the gas barrier film (D), and the latter film functions as the anticorrosion layer (E). On that occasion, as shown in Fig. 5, adhering was performed with a sealing material in such a manner that an edge part of the anticorrosion layer (E) film was disposed in the inside of the gas barrier film (D). The sealing material had a adhering line width of 3 mm and a adhering thickness of 20 μm. On the occasion of adhering the gas barrier film (D) to the glass substrate with the sealing material, the edge part of the anticorrosion layer (E) film is not superimposed on this sealing portion. As a result, there is freed from such a concern that after the device formation, water vapor or oxygen transmits through the inside of the anticorrosion layer (E) film toward the film surface direction to reach the inside of the device, thereby damaging the organic semiconductor layer.

[Example 6]

Four pieces of thin film solar cell elements of 2 mm x 2 mm as the organic semiconductor element (B) 20, which were manufactured in the same manner as that described in Example 3, were arranged at intervals of 8 mm as shown in Figs. 6 and 7. The space between the respective organic solar cell elements was sealed in the same manner as that made in the edge part of Example 3. On that occasion, the sealing material was coated and disposed in such a manner that the sealing material 8 and the organic thin film solar cell element did not come into contact with each other. A structure of this organic solar cell device is shown in Fig. 6. Incidentally, Fig. 7 is a view looking at the device in Fig. 6 from above. As to the respective members, the same members as those described in Figs. 1 to 5 are given the same

symbols, and descriptions thereof are omitted.

The organic solar cell device of Example 5 was taken out from the glove box and cut into four pieces in the air at 25 °C for 60 %. Cutting was performed in such a manner that the film portion was cut by a cutter, and the glass was then flawed and broken, thereby achieving cutting. A cut surface 10 is shown by a dotted line in Figs. 6 and 7.

The organic thin film solar cells fabricated in the Examples were subjected to performance evaluation in the following manner.

Each of the fabricated organic thin film solar cells was subjected to an accelerated test, and a change in photoelectric conversion characteristic before and after the test was compared. The accelerated test was carried out in an environment at 40 °C and 90 % RH for 24 hours using a small-sized environmental testing system (for example, SH-241, manufactured by ESPECT CORP.). Also, as to photoelectric convention characteristic values, the organic thin film solar cell was irradiated with light of an AM 1.5 G condition at an irradiation intensity of 100 $mW/cm^2$ using a solar simulator (manufactured by Bunkokeiki Co., Ltd.). From the obtained current/voltage curve, power conversion efficiency (PCE) was determined.

The performance evaluation results of the Examples are shown in Table 2.

Table 2

| | Rate of change in PCE | |
|---|---|---|
| Example 3 | 0.91 | |
| Example 4 | 0.89 | |
| Example 5 | 0.91 | |
| Example 6 | 0.88 | (Average value of four elements) |

As demonstrated in the results shown in Table 2, it has become clear that the organic thin film solar cells of Examples 3 to 6 have substantially the same rate of change in PCE, are small in the deterioration by the accelerated test, and are excellent.

By interposing the layer (C) containing a scavenger by the gas barrier film (D) and the anticorrosion layer (E) and also sealing the laminated sheet to allow it to be blocked from the outside air, even when the laminated sheet in this state was exposed to the outside air for a short period of time in the manufacturing process, by allowing it to devise as in Examples 5 and 6 in which the deterioration of the scavenger was considered to be suppressed, the deterioration of the performance was not perceived even by carrying out a treatment of fabricating plural organic thin film solar cells at once, followed by cutting out into individual solar cells.

INDUSTRIAL APPLICABILITY:

Applications of the organic electronic device according to the present invention are not limited and are arbitrary. For example, the present invention can be used for building material applications. In particular, for example, the present invention are suitable for use in exterior materials and interior materials of structures of housings, stores, office building, and the like; interior materials of tunnels, bridges, and the like; signboards; marks; and the like. Also, the present invention can be suitably used for image display appliances, planar light sources, display boards, and the like.

DESCRIPTION OF LETTERS OR NUMERALS:

1: Substrate (A)
2: Organic semiconductor layer
3: Transparent electrode
4: Metal electrode
5: Anticorrosion layer (E)
6: Layer (C) containing a scavenger
7: Gas barrier film (D)
8: Sealing material
9: Adhesive sheet
10: Cut surface
20: Organic semiconductor element (B)

## Claims

1. An organic electronic device comprising: an organic semiconductor element (B) (20) containing at least a pair of electrodes; a layer (C) (6) containing a scavenger which absorbs at least one of moisture and oxygen; and a gas barrier film (D) (7), in this order,
wherein the organic electronic device comprises at least one anticorrosion layer (E) (5) between at least one of the pair of electrodes of the organic semiconductor element (B) (20) and the layer (C) (6) containing a scavenger which absorbs at least one of the moisture and oxygen;
the anticorrosion layer (E) (5) has a film thickness of 20 $\mu$m or more; and
the anticorrosion layer (E) (5) and the gas barrier film (D) (7) satisfy requirements of the following expressions (1) and (2):

$$15 \geq Pe > Pd \qquad (1)$$

$$10^{-4} \leq Pd \leq 10^{-1} \qquad (2)$$

wherein Pe represents a water vapor transmission rate of the anticorrosion layer (E) (5) in an environment at 40 °C and 90 % RH, and Pd represents a water vapor transmission rate of the gas barrier film (D) (7) in an environment at 40 °C. and 90 % RH, and the units thereof are all defined in terms of g/m$^2$/day.

2. The organic electronic device according to claim 1, wherein the anticorrosion layer (E) (5) includes a layer having an adhering ability to the element electrode and the layer (C) containing a scavenger with an adhering strength 0.1 N/cm or more, as determined via the determination of peel strength of adhered assemblies in conformity with JIS K 6854.

3. The organic electronic device according to claim 1 or 2, wherein the organic semiconductor element (B) (20) is an organic solar cell element.

4. The organic electronic device according to any one of claims 1 to 3, wherein the layer (C) (6) containing a scavenger which absorbs at least one of moisture and oxygen has a moisture absorptivity of 0.1 mg/cm$^2$ or more and not more than 15 mg/cm$^2$.

5. The organic electronic device according to any one of claims 1 to 4, wherein the gas barrier film (D) (7) is a film including a thermoplastic resin and $SiO_x$ vacuum-deposited on the thermoplastic resin.

6. The organic electronic device according to any one of claims 1 to 5, which comprises a substrate (A) (1).

7. The organic electronic device according to any one of claims 1 to 6, which comprises an encapsulant and a weather resistant protective sheet.

8. A method for manufacturing an organic electronic device comprising: a substrate (A) (1); an organic semiconductor element (B) (20) containing at least a pair of electrodes; a layer (C) (6) containing a scavenger which absorbs at least one of moisture and oxygen; at least one anticorrosion layer (E) (5); and a gas barrier film (D) (7) for covering the organic semiconductor element (B) (20) as laminated, in this order,
wherein the anticorrosion layer (E) (5) and the gas barrier film (D) (7) satisfy requirements of the following expressions (1) and (2):

$$15 \geq Pe > Pd \qquad (1)$$

$$10^{-4} \leq Pd \leq 10^{-1} \qquad (2)$$

wherein Pe represents a water vapor transmission rate of the anticorrosion layer (E) (5) in an environment at 40 °C and 90 % RH, and Pd represents a water vapor transmission rate of the gas barrier film (D) (7) in an environment

at 40 °C and 90 % RH, and the units thereof are all defined in terms of $g/m^2$/day,
wherein the method comprises: manufacturing a laminate layer by laminating the at least one anticorrosion layer (E) (5) on the layer (C) (6) containing a scavenger which absorbs at least one of moisture and oxygen; manufacturing the organic semiconductor element (B) (20) on the substrate (A) (1); and laminating the layers in the foregoing order.

**9.** The method for manufacturing an organic electronic device according to claim 8, wherein the gas barrier film (D) (7), the layer (C) (6) containing a scavenger which absorbs at least one of moisture and oxygen, and the at least one anticorrosion layer (E) (5) are laminated in this order, to manufacture a laminate layer, and the organic semiconductor element (B) (20) is manufactured on the substrate (A) (1), and the layers are laminated in the foregoing order.

## Patentansprüche

**1.** Eine organische elektronische Vorrichtung, umfassend: ein organisches Halbleiterelement (B)(20), welches mindestens ein Elektrodenpaar enthält; eine Schicht (C)(6) enthaltend einen Scavenger, welcher Feuchtigkeit und/oder Sauerstoff absorbiert; und eine Gasbarrierefolie (D)(7), in dieser Reihenfolge,
wobei die organische elektronische Vorrichtung mindestens eine Antikorrosionsschicht (E)(5) zwischen mindestens einem/einer aus dem Elektrodenpaar des organischen Halbleiterelements (B)(20) und der Schicht (C)(6) enthaltend einen Scavenger, welcher Feuchtigkeit und/oder Sauerstoff absorbiert, umfasst;
die Antikorrosionsschicht (E)(5) eine Filmdicke von 20 μm oder mehr aufweist; und
die Antikorrosionsschicht (E)(5) und die Gasbarrierefolie (D)(7) die Erfordernisse der folgenden Formeln (1) und (2) erfüllen:

$$15 \geq Pe > Pd \qquad (1)$$

$$10^{-4} \leq Pd \leq 10^{-1} \qquad (2),$$

wobei Pe eine Wasserdampfdurchgangsgeschwindigkeit der Antikorrosionsschicht (E)(5) in einer Umgebung von 40 °C und 90 % relativer Feuchte darstellt, und Pd eine Wasserdampfdurchgangsgeschwindigkeit der Gasbarrierefolie (D)(7) in einer Umgebung von 40 °C und 90 % relativer Feuchte darstellt, und die Einheiten davon alle in Form von $g/m^2$/Tag definiert sind.

**2.** Die organische elektronische Vorrichtung gemäß Anspruch 1, wobei die Antikorrosionsschicht (E)(5) eine Schicht einschließt, welche eine Haftfähigkeit an die Elementelektrode und die Schicht enthaltend einen Scavenger mit einer Haftfestigkeit von 0,1 N/cm oder mehr, bestimmt mittels Messung der von gefügten Anordnung in Übereinstimmung mit JIS K 6854, aufweist.

**3.** Die organische elektronische Vorrichtung gemäß Anspruch 1 oder 2, wobei das organische Halbleiterelement (B)(20) ein organisches Solarzellenelement ist.

**4.** Die organische elektronische Vorrichtung gemäß einem der Ansprüche 1 bis 3, wobei die Schicht (C)(6) enthaltend einen Scavenger welcher Feuchtigkeit und/oder Sauerstoff absorbiert, eine Feuchtigkeits-Absorptionsfähigkeit von 0,1 $mg/cm^2$ oder mehr und nicht mehr als 15 $mg/cm^2$ aufweist.

**5.** Die organische elektronische Vorrichtung gemäß einem der Ansprüche 1 bis 4, wobei die Gasbarrierefolie (D)(7) eine Folie ist, welche ein thermoplastisches Harz und auf dem thermoplastischen Harz aufgedampftes $SiO_x$ einschließt.

**6.** Die organische elektronische Vorrichtung gemäß einem der Ansprüche 1 bis 5, welche ein Substrat (A)(1) umfasst.

**7.** Die organische elektronische Vorrichtung gemäß einem der Ansprüche 1 bis 6, welche einen Verkapselungsstoff und eine wetterbeständige Schutzschicht umfasst.

**8.** Ein Verfahren zur Herstellung einer organischen elektronischen Vorrichtung, umfassend: ein Substrat (A)(1); ein

organisches Halbleiterelement (B)(20), welches mindestens ein Elektrodenpaar enthält; eine Schicht (C)(6) enthaltend einen Scavenger, welcher Feuchtigkeit und/oder Sauerstoff absorbiert; mindestens eine Antikorrosionsschicht (E)(5); und eine Gasbarrierefolie (D)(7) zum Abdecken des organischen Halbleiterelements (B)(20) wie laminiert, in dieser Reihenfolge,
wobei die Antikorrosionsschicht (E)(5) und die Gasbarrierefolie (D)(7) die Erfordernisse der folgenden Formeln (1) und (2) erfüllen:

$$15 \geq Pe > Pd \qquad (1)$$

$$10^{-4} \leq Pd \leq 10^{-1} \qquad (2),$$

wobei Pe eine Wasserdampfdurchgangsgeschwindigkeit der Antikorrosionsschicht (E)(5) in einer Umgebung von 40 °C und 90 % relativer Feuchte darstellt, und Pd eine Wasserdampfgangsgeschwindigkeit der Gasbarrierefolie (D)(7) in einer Umgebung von 40 °C und 90 % relativer Feuchte darstellt, und die Einheiten davon alle in Form von g/m$^2$/Tag definiert sind,
wobei das Verfahren umfasst: Herstellen einer Laminatschicht durch Laminieren der mindestens einen Antikorrosionsschicht (E)(5) auf die Schicht (C)(6) enthaltend einen Scavenger, welcher Feuchtigkeit und/oder Sauerstoff absorbiert; Herstellen des organischen Halbleiterelements (B)(20) auf dem Substrat (A)(1); und Laminieren der Schichten in vorgenannter Reihenfolge.

**9.** Das Verfahren zur Herstellung einer organischen elektronischen Vorrichtung gemäß Anspruch 8, wobei die Gasbarrierefolie (D)(7), die Schicht (C)(6) enthaltend einen Scavenger, welcher Feuchtigkeit und/oder Sauerstoff absorbiert, und die mindestens eine Antikorrosionsschicht (E)(5) in dieser Reihenfolge laminiert sind, um eine Laminatschicht herzustellen, und das organische Halbleiterelement (B)(20) auf dem Substrat (A)(1) hergestellt ist, und die Schichten in der vorgenannten Reihenfolge laminiert sind.

## Revendications

**1.** Dispositif électronique organique comprenant : un élément semi-conducteur organique (B) (20) contenant au moins une paire d'électrodes ; une couche (C) (6) contenant un agent d'élimination qui absorbe au moins l'un de l'humidité et de l'oxygène ; et un film de barrière aux gaz (D) (7), dans cet ordre,
dans lequel le dispositif électronique organique comprend au moins une couche anticorrosion (E) (5) entre au moins l'une de la paire d'électrodes de l'élément semi-conducteur organique (B) (20) et la couche (C) (6) contenant un agent d'élimination qui absorbe au moins l'un de l'humidité et de l'oxygène ;
la couche anticorrosion (E) (5) a une épaisseur de film de 20 $\mu$m ou plus ; et
la couche anticorrosion (E) (5) et le film de barrière aux gaz (D) (7) satisfont aux spécifications des expressions (1) et (2) suivantes :

$$15 \geq Pe > Pd \qquad (1)$$

$$10^{-4} \leq Pd \leq 10^{-1} \qquad (2)$$

où Pe représente un taux de transmission de vapeur d'eau de la couche anticorrosion (E) (5) dans un environnement à 40 °C et 90 % d'humidité relative, et Pd représente un taux de transmission de vapeur d'eau du film de barrière aux gaz (D) (7) dans un environnement à 40 °C et 90 % d'humidité relative, et les unités de ceux-ci sont toutes définies en termes de g/m$^2$/jour.

**2.** Dispositif électronique organique selon la revendication 1, dans lequel la couche anticorrosion (E) (5) comprend une couche ayant une capacité d'adhérence à l'électrode de l'élément et à la couche (C) contenant un agent d'élimination avec une force d'adhérence de 0,1 N/cm ou plus, telle que déterminée par la détermination de la résistance au pelage des assemblages collés en conformité avec la norme JIS K 6854.

**3.** Dispositif électronique organique selon la revendication 1 ou 2, dans lequel l'élément semi-conducteur organique (B) (20) est un élément de cellule solaire organique.

**4.** Dispositif électronique organique selon l'une quelconque des revendications 1 à 3, dans lequel la couche (C) (6) contenant un agent d'élimination qui absorbe au moins l'un de l'humidité et de l'oxygène a une capacité d'absorption de l'humidité de 0,1 $mg/cm^2$ ou plus et ne dépassant pas 15 $mg/cm^2$.

**5.** Dispositif électronique organique selon l'une quelconque des revendications 1 à 4, dans lequel le film de barrière aux gaz (D) (7) est un film comprenant une résine thermoplastique et du $SiO_x$ déposé sous vide sur la résine thermoplastique.

**6.** Dispositif électronique organique selon l'une quelconque des revendications 1 à 5, qui comprend un substrat (A) (1).

**7.** Dispositif électronique organique selon l'une quelconque des revendications 1 à 6, qui comprend un agent d'encapsulation et une feuille de protection résistant aux intempéries.

**8.** Procédé de fabrication d'un dispositif électronique organique comprenant : un substrat (A) (1) ; un élément semi-conducteur organique (B) (20) contenant au moins une paire d'électrodes ; une couche (C) (6) contenant un agent d'élimination qui absorbe au moins l'un de l'humidité et de l'oxygène ; au moins une couche anticorrosion (E) (5) ; et un film de barrière aux gaz (D) (7) pour recouvrir l'élément semi-conducteur organique (B) (20) tels que lamifiés, dans cet ordre,
dans lequel la couche anticorrosion (E) (5) et le film de barrière aux gaz (D) (7) satisfont aux spécifications des expressions (1) et (2) suivantes :

$$15 \geq Pe > Pd \qquad (1)$$

$$10^{-4} \leq Pd \leq 10^{-1} \qquad (2)$$

où Pe représente un taux de transmission de vapeur d'eau de la couche anticorrosion (E) (5) dans un environnement à 40 °C et 90 % d'humidité relative, et Pd représente un taux de transmission de vapeur d'eau du film de barrière aux gaz (D) (7) dans un environnement à 40 °C et 90 % d'humidité relative, et les unités de ceux-ci sont toutes définies en termes de $g/m^2$/jour,
dans lequel le procédé comprend : la fabrication d'une couche stratifiée en lamifiant ladite au moins une couche anticorrosion (E) (5) sur la couche (C) (6) contenant un agent d'élimination qui absorbe au moins l'un de l'humidité et de l'oxygène ; la fabrication de l'élément semi-conducteur organique (B) (20) sur le substrat (A) (1) ; et la lamification des couches dans l'ordre ci-dessus.

**9.** Procédé de fabrication d'un dispositif électronique organique selon la revendication 8, dans lequel le film de barrière aux gaz (D) (7), la couche (C) (6) contenant un agent d'élimination qui absorbe au moins l'un de l'humidité et de l'oxygène et ladite au moins une couche anticorrosion (E) (5) sont lamifiés dans cet ordre, pour fabriquer une couche stratifiée, et l'élément semi-conducteur organique (B) (20) est fabriqué sur le substrat (A) (1), et les couches sont lamifiées dans l'ordre ci-dessus.

[Fig. 1]

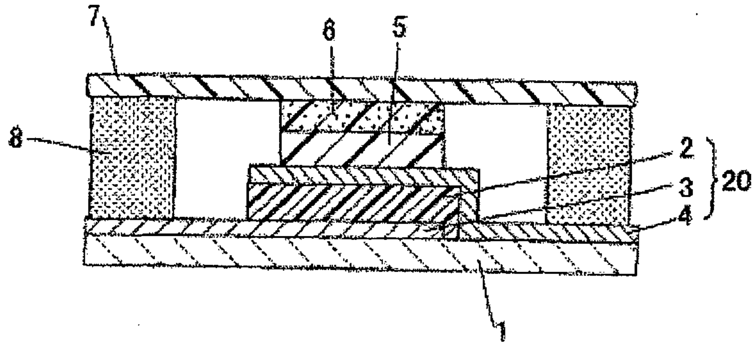


[Fig. 2]

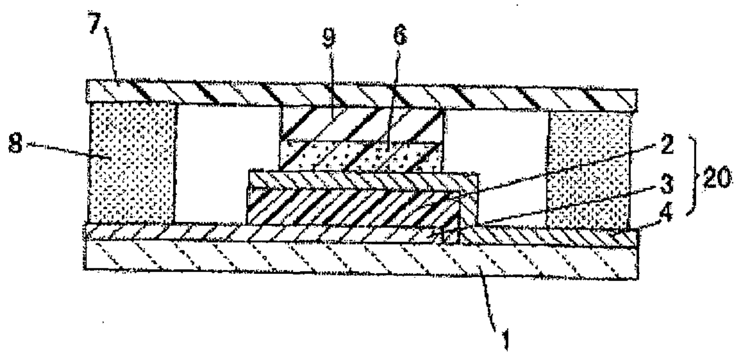


[Fig. 3]

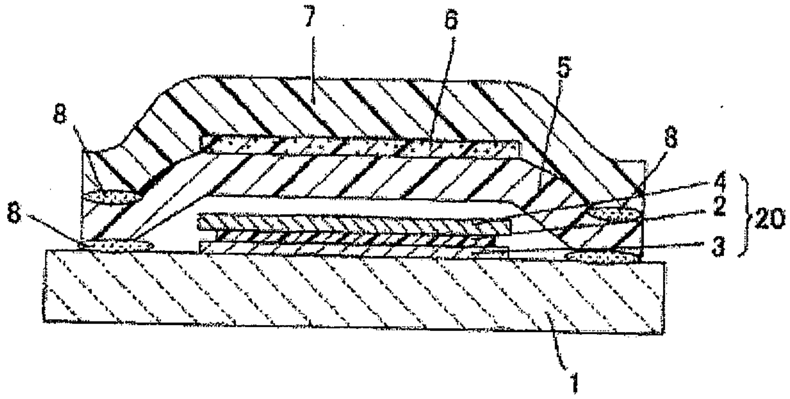

[Fig. 4]

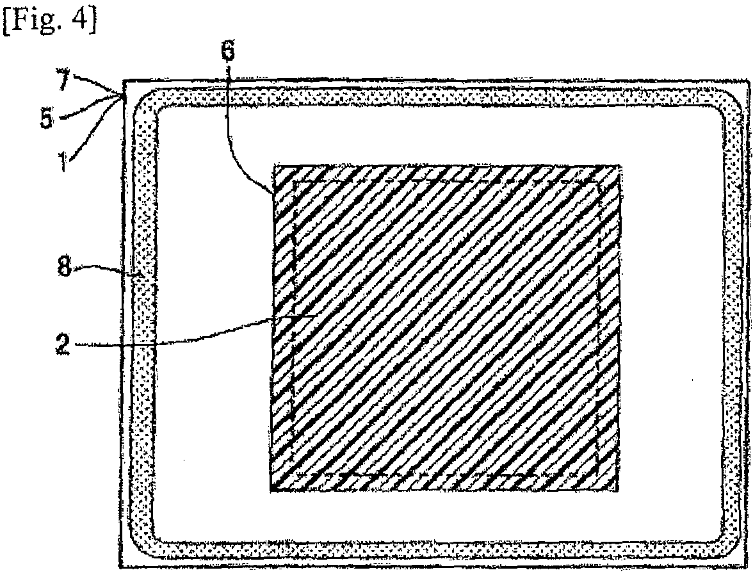


[Fig. 5]

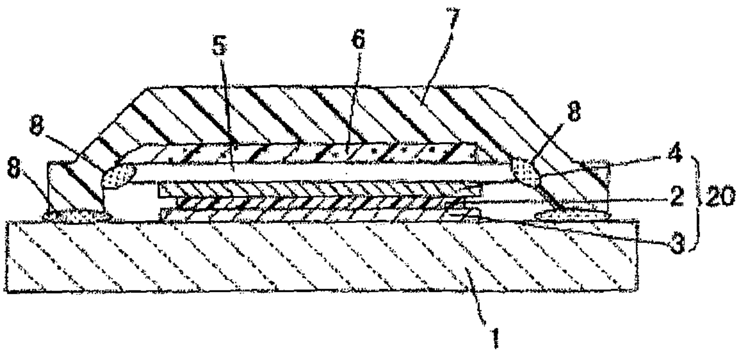


[Fig. 6]

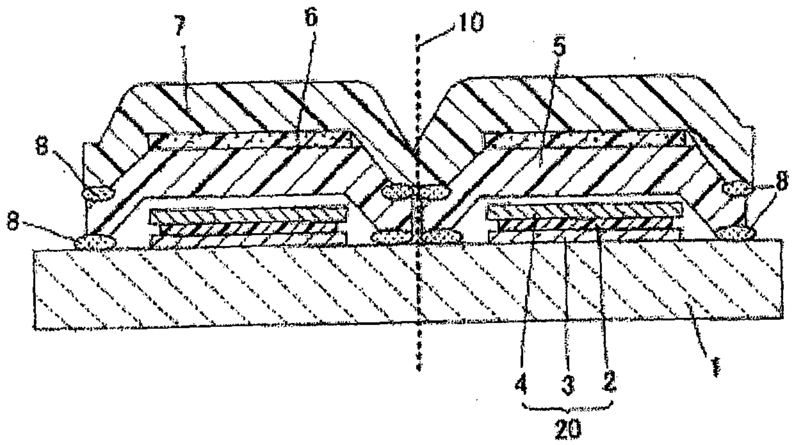

[Fig. 7]

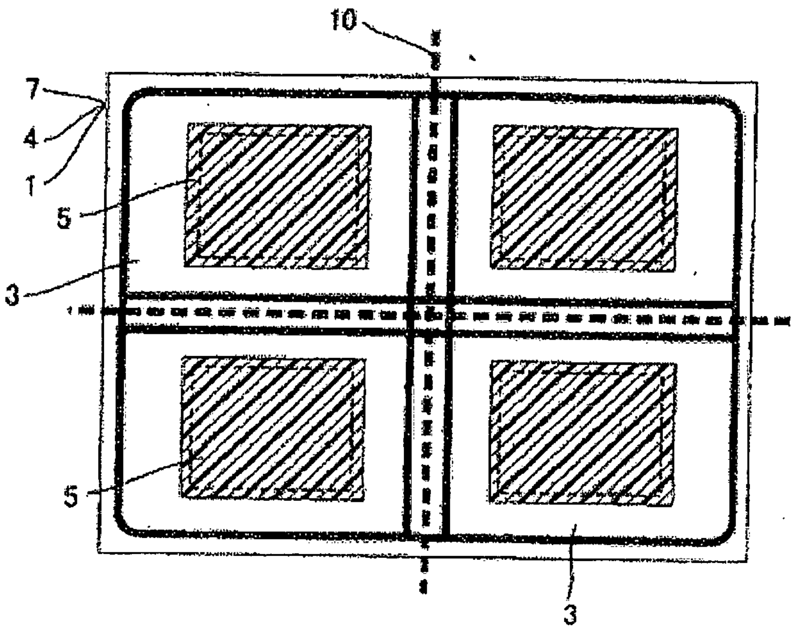

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007516611 T
- JP 2009099805 A
- US 2007295390 A1